# EUROPÄISCHE PATENTSCHRIFT

(11) **EP 3 819 646 B1**
(45) Veröffentlichungstag und Bekanntmachung des Hinweises auf die Patenterteilung: **31.12.2025**
(21) Anmeldenummer: 20205314.6
(22) Anmeldetag: 03.11.2020
(51) Int. Cl.: G01R 1/04, G01R 31/28

(54) **MODULARES TESTSYSTEM ZUM TESTEN ELEKTRISCHER BAUGRUPPEN**
MODULAR TEST SYSTEM FOR TESTING ELECTRICAL MODULES
SYSTÈME D'ESSAI MODULAIRE PERMETTANT LES ESSAIS DES MODULES ÉLECTRIQUES

(30) Priorität: 08.11.2019 DE 102019007776
(43) Veröffentlichungstag der Anmeldung: 12.05.2021
(73) Patentinhaber: Yamaichi Electronics Deutschland GmbH, 85609 Aschheim-Dornach (DE)
(72) Erfinder: Quiter, Michael, 57482 Wenden (DE); Serna, Yoann, 6511 Zams (AT); Kahla, Hosni, 4000 Sousse (TN)
(74) Vertreter: Müller-Boré & Partner Patentanwälte PartG mbB

(56) Entgegenhaltungen:
- EP-A1- 1 995 602
- DE-U1- 202011 107 409
- US-A- 4 812 754
- US-A1- 2006 245 712

## Beschreibung

Die Erfindung betrifft ein modulares Testsystem zum Testen elektrischer Baugruppen, ein verschließbares Grundmodul für ein modulares Testsystem und ein Verfahren zum Testen elektrischer Baugruppen.

Testsysteme bzw. Prüfadapter werden zum Testen elektrischer Baugruppen eingesetzt. Dabei ist vorgesehen, dass das Testsystem eine zu testende elektrische Baugruppe aufnimmt, um diese elektrisch zu kontaktieren. Ferner ist das Testsystem mit einer Testvorrichtung bzw. einer Prüfvorrichtung elektrisch verbunden, sodass mittels des Testsystems eine elektrische Verbindung zwischen der zu testenden elektrischen Baugruppe und der Testvorrichtung bzw. Prüfvorrichtung besteht.

Zum Testen der elektrischen Baugruppe wird mittels der Testvorrichtung eine Testroutine bzw. Prüfroutine aus- bzw. durchgeführt, wobei nach Abschluss der Testroutine, die in dem Testsystem angeordnete elektrische Baugruppe durch eine andere elektrische Baugruppe ersetzt werden kann. Anschließend wird die andere elektrische Baugruppe ebenfalls mittels der Testvorrichtung getestet.

Beim Testen bauartunterschiedlicher Baugruppen ist es gegebenenfalls notwendig, das Testsystem umzurüsten bzw. zu modifizieren, sodass die elektrische Baugruppe durch das Testsystem unterstützt wird. Entsprechende Umrüstungen sind zeitaufwendig und benötigen tiefgreifende Kenntnisse des Testsystems.

Ferner betrifft die US 4 812 754 A eine Vorrichtung zum Verbinden einer Leiterplatte mit einem Testsystem. Die Vorrichtung umfasst eine Tragstruktur, die ein Paar von ersten und zweiten Testköpfen in gegenüberliegender Beziehung beweglich trägt, wobei zumindest der erste Testkopf eine Vielzahl von Sonden aufweist, mit denen Testpunkte auf einer Leiterplatte kontaktiert und getestet werden. Betätigungskomponenten ermöglichen eine Bewegung der Prüfköpfe aus einer beabstandeten Ladeposition in eine enger beabstandete Prüfposition, in der jede der Sonden in Kontakt mit einem jeweiligen der Prüfpunkte gedrängt wird. Ein elektrischer Bus koppelt ein separates Prüfsystem zumindest an den ersten Prüfkopf.

Die EP 1 995 602 A1 betrifft eine Sondenplatine zum Testen einer Zielplatine (Printed Circuit Board). Die Sondenplatine ist versehen mit Sonden zum Kontaktieren von Zielpunkten auf der Zielplatine.

Die DE 20 2011 107409 U1 betrifft eine Prüfvorrichtung für einen Prüfling, mit einem Gehäuse mit einem Gehäuseunterteil und einem zum Öffnen und Schließen des Gehäuses gegenüber dem Gehäuseunterteil beweglichen Gehäuseoberteil, wobei das Gehäuse einen Aufnahmeraum für den Prüfling ausbildet, in den eine Vielzahl von Kontaktstiften ragen, die im geschlossenen Zustand des Gehäuses an dem Prüfling anliegen, dadurch gekennzeichnet, dass zumindest eine Wand des Gehäuses eine Wabenstruktur aufweist.

Die US 2006/245712 A1 betrifft eine Testvorrichtung zum Testen optoelektronischer Module. In einer Ausführungsform kann die Testvorrichtung eine gedruckte Leiterplatte (PCB) und einen ersten Abschnitt umfassen, der an der PCB befestigt ist. An dem ersten Abschnitt kann ein zweiter Abschnitt befestigt werden. Der zweite Abschnitt kann mindestens eine Testvorrichtung umfassen, die verwendet werden kann, um ein optoelektronisches Modul zu testen, das zwischen dem ersten Abschnitt und dem zweiten Abschnitt angeordnet ist.

Es ist daher Aufgabe der vorliegenden Erfindung, ein Grundmodul für ein modulares Testsystem zum Testen elektrischer Baugruppen bereitzustellen, welches einfach und in kurzer Zeit an verschiedene elektrische Baugruppen anpassbar ist. Ferner ist es Aufgabe der vorliegenden Erfindung ein Verfahren zum Testen elektrischer Baugruppen unter Verwendung eines erfindungsgemäßen Grundmoduls für ein modularen Testsystems bereitzustellen.

Diese Aufgabe wird durch die Gegenstände der unabhängigen Ansprüche gelöst. Bevorzugte Ausführungsformen sind in den abhängigen Ansprüchen definiert.

Ein Aspekt betrifft ein modulares Testsystem zum Testen elektrischer Baugruppen, aufweisend ein verschließbares Grundmodul, ein in einem Aufnahmeraum des Grundmoduls anordenbares Testmodul, welches in einem geöffneten Zustand des Grundmoduls austauschbar ist, und ein mit dem Testmodul elektrisch verbindbares Schnittstellenmodul. Ferner weist das Testmodul einen ersten Kontaktierungsabschnitt zum Aufnehmen und elektrischen Kontaktieren einer zu testenden elektrischen Baugruppe und einen mit dem ersten Kontaktierungsabschnitt elektrisch verbundenen zweiten Kontaktierungsabschnitt zum elektrischen Verbinden der zu testenden elektrischen Baugruppe mit dem Schnittstellenmodul auf, wobei das Schnittstellenmodul dazu ausgebildet ist, das Testmodul mit einer Testvorrichtung zum Testen der elektrischen Baugruppe zu verbinden.

Das vorgeschlagene modulare Testsystem ermöglicht ein schnelles Testen bzw. Prüfen von elektrischen Baugruppen. So kann im geöffneten Zustand des Grundmoduls eine zu testende elektrische Baugruppe an dem ersten Kontaktierungsabschnitt angeordnet werden. Durch Schließen des Grundmoduls wird die zu testende elektrische Baugruppe an dem ersten Kontaktierungsabschnitt fixiert, sodass die zu testende elektrische Baugruppe durch das Testmodul und das Schnittstellenmodul mit der Testvorrichtung elektrisch verbunden ist. Die fixierte elektrische Baugruppe kann dann mittels der Tertvorrichtung getestet bzw. geprüft werden. Nach erfolgtem Test kann das Grundmodul geöffnet werden, wodurch die zu testende elektrische Baugruppe freigegeben wird, um diese auszutauschen. Zu testenden elektrische Baugruppen sind beispielsweise Halbleiterbauelemente, oder elektrische Baugruppen welche Halbleiterbauelemente aufweisen.

Für den Fall, dass mit dem Testsystem eine neue elektrische Baugruppe getestet werden soll, welche eine andere Konfiguration aufweist, kann es notwendig sein, dass das Testsystem an die neue elektrische Baugruppe angepasst werden muss. Hierzu kann erfindungsgemäß auf einfache Weise das Testmodul durch ein auf die neue Baugruppe angepasstes Testmodul getauscht werden. Ferner ermöglicht die Erfindung den einfachen Austausch eines defekten Testmoduls. Insbesondere ermöglicht die Erfindung, dass lediglich das Testmodul ausgetauscht werden muss und das während des Austauschs des Testmodul das Grundmodul mittels des Schnittstellenmoduls mit der Testvorrichtung verbunden bleiben kann. Somit kann das Testsystem schnell an unterschiedliche zu testende elektrische Baugruppen angepasst werden.

Vorzugsweise ist im geschlossenen Zustand des Grundmoduls das Testmodul im Wesentlichen von dem Grundmodul umschlossen und von außen nicht zugänglich. Des Weiteren kann der zweite Kontaktierungsabschnitt eines jeden Testmoduls entsprechend dem an dem Grundmodul angeordneten Schnittstellenmodul angepasst sein. Mit anderen Worten, das Testmodul stellt eine Zuordnung der elektrischen Kontaktierung der zu testenden Baugruppe auf das Schnittstellenmodul bereit.

In einem nicht beanspruchten Beispiel kann das modulare Testsystem auch ohne Schnittstellenmodul verwendet werden, in dem der zweite Kontaktierungsabschnitt direkt mit der Testvorrichtung elektrisch verbunden wird. Mit anderen Worten, die zu testende elektrische Baugruppe ist nur über das Testmodul mit der Testvorrichtung elektrisch verbunden.

Vorzugsweise ist vorgesehen, dass im geöffneten Zustand des Grundmoduls das Grundmodul das Testmodul freigeben kann, sodass das Testmodul durch ein anderes Testmodul austauschbar ist. Auf vorteilhafte Weise ist somit ein einfacher Wechsel des Testmoduls möglich.

Insbesondere kann vorgesehen sein, dass das Testmodul im geöffneten Zustand des Grundmoduls mit dem Grundmodul verriegelt bzw. von diesem entriegelt werden kann. Im verriegelten Zustand des Testmoduls mit dem Grundmodul ist der zweite Kontaktierungsabschnitt des Testmoduls elektrisch und/oder physisch mit dem Schnittstellenmodul verbunden. Durch Entriegeln des Testmoduls von dem Grundmodul wird das Testmodul freigegeben, sodass ein Austausch des Testmoduls möglich ist. Ferner wird durch das Entriegeln des Testmoduls von dem Grundmodul die elektrische und/oder physikalische Verbindung zwischen dem Testmodul bzw. dem zweiten Kontaktierungsabschnitt und dem Schnittstellenmodul getrennt. Das Testmodul kann anschließend aus dem Aufnahmeraum des Grundmoduls entnommen werden und ein anderes Testmodul in den Aufnahmeraum angeordnet bzw. eingesetzt werden.

Vorzugsweise weist das Grundmodul ein Fixierungsmodul auf, welches dazu ausgebildet ist, im geschlossenen Zustand des Grundmoduls, eine zu testende elektrische Baugruppe an dem ersten Kontaktierungsabschnitt zu fixieren. Ferner kann das Fixierungsmodul mittels einer Verriegelung mit dem Grundmodul kuppelbar sein.

Zum einen ermöglicht das Vorsehen eines Fixierungsmoduls, dass die zu testende elektrische Baugruppe sicher an dem ersten Kontaktierungsabschnitt fixiert werden kann, um die zu testende elektrische Baugruppe sicher testen zu können. Zum anderen ermöglicht das mit dem Grundmodul kuppelbare Fixierungsmodul, dass das Fixierungsmodul schnell und einfach durch ein anderes Fixierungsmodul ausgetauscht werden kann. Insbesondere kann der Austausch des Fixierungsmoduls und auch des Testmoduls ohne Werkzeug erfolgen. Vielmehr kann die Verriegelung das Fixierungsmodul an dem Grundmodul sichern und durch Lösen der Verriegelung kann das Fixierungsmodul schnell von dem Grundmodul getrennt werden.

Vorzugsweise weist das Grundmodul ein erstes Unterstützungsglied auf, welches den Aufnahmeraum bereitstellt, in dem das Testmodul angeordnet werden kann. Ferner kann ein zweites Unterstützungsglied an dem ersten Unterstützungsglied verschwenkbar in Bezug auf das erste Unterstützungsglied angeordnet sein, wobei durch Verschwenken des zweiten Unterstützungsglieds das Grundmodul geöffnet und geschlossen werden kann. Insbesondere kann das zweite Unterstützungsglied die zuvor erwähnte Verriegelung aufweisen, mit der das Fixierungsmodul mit dem zweiten Unterstützungsglied kuppelbar ist. Mit anderen Worten, das Fixierungsmodul ist mit dem zweiten Unterstützungsglied kuppelbar und somit an dem zweiten Unterstützungsglied angeordnet. Durch Verschwenken des zweiten Unterstützungsglieds relativ zu dem ersten Unterstützungsglied kann somit auch das Fixierungsmodul relativ zu dem ersten Unterstützungsglied verschwenkt werden. Vorzugsweise kann vorgesehen sein, dass das Fixierungsmodul schwimmend an dem zweiten Unterstützungsglied gelagert ist. Dadurch ist es möglich, dass sich das Fixierungsmodul beim Schließen des Grundmoduls optimal an die in dem Testmodul angeordnete zu testende elektrische Baugruppe ausrichtet.

Vorzugsweise kann das Fixierungsmodul fixierungsmodulseitige Kontaktierungsmittel aufweisen, mit denen die zu testende elektrische Baugruppe und oder das Testmodul elektrisch kontaktiert werden kann. Ferner kann das fixierungsmodulseitige Kontaktierungsmittel aus dem Grundmodul nach außen geführt werden, um das fixierungsmodulseitige Kontaktierungsmittel mit der Testvorrichtung oder anderen elektrischen Vorrichtungen elektrisch zu verbinden. Vorzugsweise können das Fixierungsmodul und das Testmodul aufeinander abgestimmt sein. D.h., dass Fixierungsmodul und das Testmodul können dazu ausgebildet sein, eine bestimmte zu testende elektrische Baugruppe oder bestimmte zu testende elektrische Baugruppen zu unterstützen. Ein Wechsel des Fixierungsmoduls und des Testmoduls kann somit in Abhängigkeit der zu testende elektrischen Baugruppe erfolgen, wodurch das Testsystem an unterschiedlichste zu testende elektrische Baugruppen anpassbar ist.

Erfindungsgemäß ist das Schnittstellenmodul lösbar mit dem Grundmodul verbunden. D.h., das Schnittstellenmodul ist nicht integral mit dem Grundmodul ausgebildet.

Erfindungsgemäß kann das Schnittstellenmodul an dem Grundmodul verschraubt werden, an dem Grundmodul verriegelt werden oder an das Grundmodul geklemmt werden. Somit kann das Schnittstellenmodul je nach Bedarf getauscht werden wodurch beispielsweise eine hohe Anpassbarkeit des Testsystems an unterschiedliche Testvorrichtungen gewährleistet wird.

Vorzugsweise ist vorgesehen, dass das Schnittstellenmodul das Testmodul unmittelbar mit der Testvorrichtung verbinden kann. Mit anderen Worten, die Verbindung des Testmoduls mit der Testvorrichtung erfolgt ausschließlich über das Schnittstellenmodul. Optional kann allerdings vorgesehen sein, dass wie oben beschrieben, dass Testmodul auch mittels der fixierungsmodulseitigen Kontaktierungsmittel mit der Testvorrichtung elektrisch verbunden ist. Somit ist es auf vorteilhafte Weise möglich, dass Testsystem schnell an eine neue zu testende elektrische Baugruppe anzupassen, da lediglich das Testmodul getauscht werden brauch und die mittels des Schnittstellenmoduls bereitgestellte Verbindung zu der Testvorrichtung nicht gelöst werden brauch.

Das Schnittstellenmodul weist einen grundmodulseitigen Kontaktierungsabschnitt auf, der mittels Kontaktverbindern elektrisch mit dem zweiten Kontaktierungsabschnitt des Testmoduls verbindbar ist. Ferner kann das Schnittstellenmodul einen testvorrichtungsseitigen Kontaktierungsabschnitt aufweisen, der dazu ausgebildet, das Schnittstellenmodul mit der Testvorrichtung zu verbinden.

Insbesondere sind der zweite Kontaktierungsabschnitt des Testmoduls und der grundmodulseitige Kontaktierungsabschnitt des Schnittstellenverbinders als Kontaktverbinder ausgebildet, sodass eine elektrische Verbindung zwischen dem Testmodul und Schnittstellenmodul durch kontaktieren des grundmodulseitige Kontaktierungsabschnitts mit dem zweiten Kontaktierungsabschnitt hergestellt werden kann. Ferner ermöglicht das Vorsehen eines Kontaktverbinders, dass die elektrische Verbindung zwischen dem zweiten Kontaktierungsabschnitt und dem grundmodulseitige Kontaktierungsabschnitt einfach getrennt werden kann.

Vorzugsweise kann der Kontaktverbinder oder die Kontaktverbinder als Pylonstecker ausgebildet sind. D.h., die elektrische Verbindung zwischen dem zweiten Kontaktierungsabschnitt und dem grundmodulseitige Kontaktierungsabschnitt kann zumindest teilweise mittels Pylonstecker realisiert werden. Vorzugsweise weist der zweite Kontaktierungsabschnitt einen oder mehrere Pylonblöcke auf, welche mit korrespondierenden Adapter-Pylonblöcken des grundmodulseitigen Kontaktierungsabschnitts elektrisch verbunden werden können. Alternativ kann der grundmodulseitige Kontaktierungsabschnitt einen oder mehrere Pylonblöcke aufweisen, die mit korrespondierenden Adapter-Pylonblöcken des zweiten Kontaktierungsabschnitts elektrisch verbindbar sind.

Vorzugsweise können der erste Kontaktierungsabschnitt und der zweite Kontaktierungsabschnitt zumindest teilweise, bevorzugt vollständig, mittels Wire-Wrapping elektrisch miteinander verbunden sein. Ferner kann der grundmodulseitige Kontaktierungsabschnitt des Schnittstellenmoduls zumindest teilweise, bevorzugt vollständig, mittels Wire-Wrapping mit einem testvorrichtungsseitigen Kontaktierungsabschnitt des Schnittstellenmoduls verbunden, wobei der testvorrichtungsseitige Kontaktierungsabschnitt dazu ausgebildet ist, elektrische mit der Testvorrichtung verbunden zu werden.

Vorzugsweise weist das Grundmodul eine Bedieneinheit auf, wobei durch Betätigen der Bedieneinheit der zweite Kontaktierungsabschnitt von dem Schnittstellenmodul elektrisch und/oder physisch trennbar und/oder mit diesem verbindbar ist. Folglich kann durch Betätigen der Bedieneinheit das Testmodul einfach von dem Schnittstellenmoduls getrennt werden oder mit diesem verbunden werden.

Ferner kann vorteilhaft vorgesehen werden, dass die Bedieneinheit nur im geöffneten Zustand des Grundmoduls betätigt werden kann, wodurch ein versehentliches Trennen des Testmoduls vom Schnittstellenmoduls während des Testens der elektrischen Baugruppe verhindert wird. Ferner kann vorgesehen sein, dass zum Schließen des Grundmoduls die Bedieneinheit eine Position eingenommen hat, in der das Testmodul mit dem Grundmodul verriegelt ist, sodass das Testmodul sicher elektrisch und/oder physisch mit dem Schnittstellenmodul verbunden ist.

Vorzugsweise weist das Grundmodul ein Aufnahmeglied auf, auf welches das Testmodul aufgesetzt werden kann. Dabei kann vorgesehen sein, dass das Aufnahmeglied beweglich in Bezug auf das erste Unterstützungsglied gelagert ist.

Insbesondere kann das Aufnahmeglied linear führbar sein, sodass es in einer Ebene beweglich gelagert ist. Die Ebene kann bevorzugt horizontal verlaufen für den Fall, dass das Testsystem auf einem horizontal verlaufenden Untergrund angeordnet ist. Für den Fall, dass das Aufnahmeglied in der Ebene bewegt wird erfährt auch das in dem Aufnahmeglied eingesetzte Testmodul eine Bewegung in der Ebene.

Des Weiteren kann die Bedieneinheit verschwenkbar bzw. drehbar an dem Grundmodul, insbesondere an dem ersten Unterstützungsglied angeordnet sein. Ferner weist die Bedieneinheit eine Kulissenführung auf, in welche ein Nockenelement des Aufnahmeglieds eingreift. Durch Bewegen bzw. Verschwenken der Bedieneinheit wird das Nockenelement in der Kulissenführung entlanggeführt, wodurch das Aufnahmeglied in der Ebene bewegt wird.

Vorzugsweise erfährt durch Betätigen der Bedieneinheit das Testmodul eine Relativbewegung in Bezug auf das Schnittstellenmodul, sodass das Testmodul elektrisch und/oder physisch von dem Schnittstellenmodul trennbar und/oder mit diesem verbindbar ist. Insbesondere kann die Bedieneinheit in eine Entriegelungsposition bewegt werden, wenn das Grundmodul geöffnet ist, wobei beim Bewegen der Bedieneinheit in die Entriegelungsposition das Testmodul von dem Schnittstellenmodul wegbewegt wird.

Ferner kann die Bedieneinheit in eine Verriegelungsposition bewegt werden, wobei beim Bewegen der Bedieneinheit in die Verriegelungsposition das Testmodul an das Schnittstellenmodul bewegt wird, sodass der zweite Kontaktierungsabschnitt des Testmoduls den grundmodulseitigen Kontaktierungsabschnitt des Schnittstellenmoduls elektrisch kontaktiert.

Ein weiterer Aspekt betrifft ein verschließbares Grundmodul eines modularen Testsystems, aufweisend:
einen Aufnahmeraum zum Anordnen eines Testmoduls, wobei das Testmodul einen ersten Kontaktierungsabschnitt zum Aufnehmen und elektrischen Kontaktieren einer zu testenden elektrischen Baugruppe aufweist, und wobei in einem geöffneten Zustand des Grundmoduls das Testmodul austauschbar ist; und
ein mit dem Testmodul elektrisch verbindbares Schnittstellenmodul, wobei das Schnittstellenmodul elektrisch mit einem zweiten Kontaktierungsabschnitt des Testmoduls verbindbar ist, um das Testmodul mit einer Testvorrichtung zum Testen der elektrischen Baugruppe zu verbinden.

Ferner kann das Grundmodul wie oben beschrieben ausgebildet sein.

Ein weiterer Aspekt betrifft ein verschließbares Grundmodul eines modularen Testsystems, aufweisend:
einen Aufnahmeraum zum Anordnen eines Testmoduls, wobei das Testmodul einen ersten Kontaktierungsabschnitt zum Aufnehmen und elektrischen Kontaktieren einer zu testenden elektrischen Baugruppe aufweist, und wobei in einem geöffneten Zustand des Grundmoduls das Testmodul austauschbar ist; und
wobei das Grundmodul eine Verriegelung aufweist, mittels derer ein Fixierungsmodul an dem Grundmodul kuppelbar ist,
wobei das Fixierungsmodul im geschlossenen Zustand des Grundmoduls, die zu testende elektrische Baugruppe an dem ersten Kontaktierungsabschnitt fixiert.

Ferner kann das Grundmodul wie oben beschrieben ausgebildet sein.

Ein weiterer Aspekt betrifft ein Verfahren zum Testen elektrischer Baugruppen, aufweisend:
Bereitstellen eines zuvor beschriebenen modularen Testsystems;
Verbinden des Schnittstellenmoduls mit einer Testvorrichtung;
Anordnen eines Testmoduls in dem Aufnahmeraum des Grundmoduls;
Aufnehmen einer zu testenden elektrischen Baugruppe durch den ersten Kontaktierungsabschnitt des Testmoduls;
Verschließen des Grundmoduls; und
Testen der elektrischen Baugruppe mittels der Testvorrichtung.

Vorzugsweise kann das Verfahren weiter aufweisen:
Öffnen des Grundmoduls;
Austauschen des Testmoduls durch ein anderes Testmodul;
Aufnehmen einer zu testenden elektrischen Baugruppe durch den ersten Kontaktierungsabschnitt des anderen Testmoduls;
Verschließen des Grundmoduls; und
Testen der elektrischen Baugruppe mittels der Testvorrichtung.

Im Folgenden wird eine Ausführungsform der Erfindung anhand der beiliegenden Figuren näher beschrieben. Es versteht sich, dass die vorliegende Erfindung nicht auf diese Ausführungsform beschränkt ist, und dass einzelne Merkmale der Ausführungsform im Rahmen der beiliegenden Ansprüche zu weiteren Ausführungsformen kombiniert werden können.

Es zeigen:
- Figur 1: eine perspektivische Ansicht eines geöffneten Zustands eines modularen Testsystems in welchem ein Testmodul angeordnet ist;
- Figur 2: eine perspektivische Ansicht des modularen Testsystems im geschlossenen Zustand;
- Figur 3: eine perspektivische Ansicht des modularen Testsystems ohne Testmodul;
- Figur 4: eine perspektivische Ansicht des Testmoduls;
- Figur 5: eine Seitenansicht des Testmoduls;
- Figur 6: eine Vorderseite des modularen Testsystems;
- Figuren 7 und 8: jeweils eine Seitenansicht des modularen Testsystems zur Veranschaulichung des Austauschs des Testmoduls;
- Figuren 9 bis 13: jeweils eine Seitenansicht des modularen Testsystems zur Veranschaulichung des Schließens des Testsystems;
- Figuren 14 und 15: einen Querschnitt des Testsystems;
- Figuren 16 und 17: eine weitere Ausführungsform des modularen Testsystems.

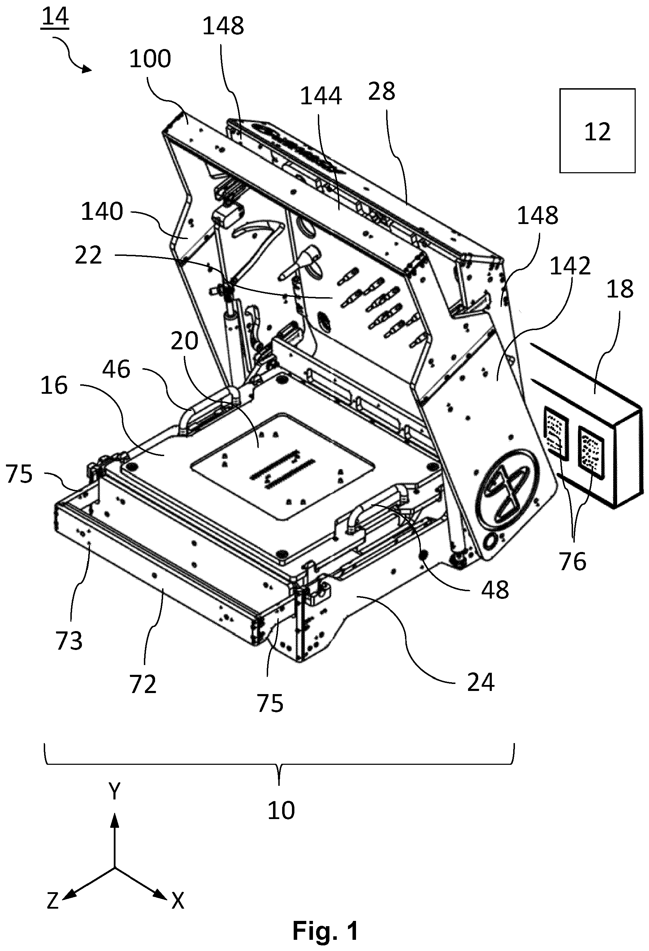

Figur 1 zeigt eine perspektivische Ansicht eines modularen Testsystems 10, welches mit einer Testvorrichtung 12 elektrisch verbindbar ist. Das modulare Testsystem 10 kann ein Grundmodul 14, ein in bzw. an dem Grundmodul 14 anordenbares Testmodul 16 und ein mit dem Grundmodul 14 verbindbares Schnittstellenmodul 18 aufweisen. Die Testvorrichtung 12 kann insbesondere elektrisch an dem Schnittstellenmodul 18 angeschlossen bzw. mit diesem verbunden werden. Ferner kann die Testvorrichtung 12 auch direkt an dem Testmodul 16 angeschlossen werden.

Figur 1 zeigt das Grundmodul 14 in einem geöffneten Zustand, in welchem das Testmodul 16 freigegeben werden kann. An dem Testmodul 16 kann ferner eine zu testende elektrische Baugruppe (nicht gezeigt) angeordnet werden.

In einer ersten Ausführungsform des Testmoduls 16, kann das Testmodul 16 einen ersten Kontaktierungsabschnitt 20 aufweisen, an dem im geöffneten Zustand des Grundmoduls 14 die zu testende elektrische Baugruppe angeordnet werden kann. Dabei ist vorgesehen, dass der erste Kontaktierungsabschnitt 20 die zu testende elektrische Baugruppe elektrisch kontaktiert.

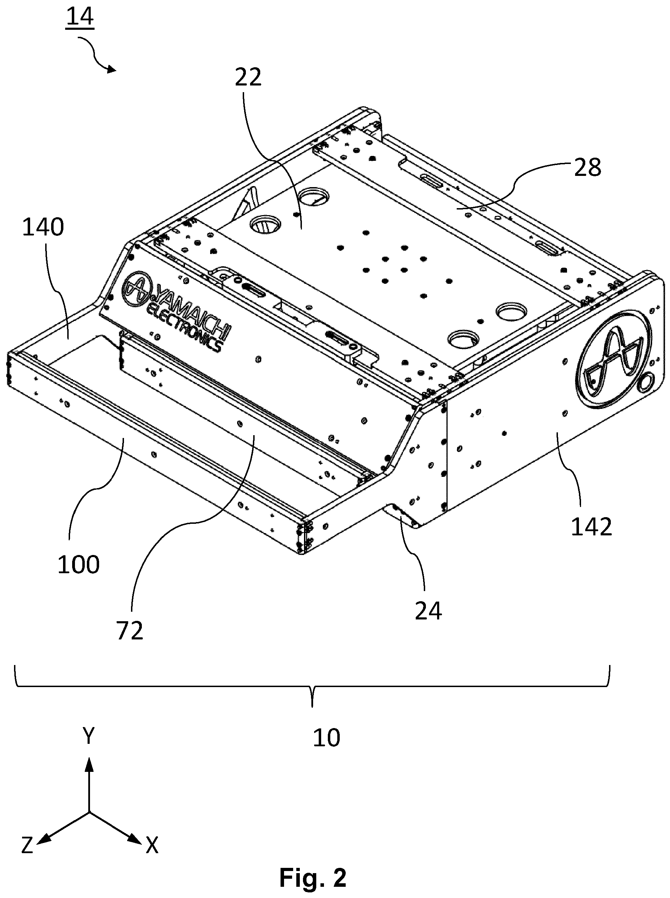

Des Weiteren weist das Grundmodul 14 ein Fixierungsmodul 22 auf, welches in dem in Figur 2 gezeigten geschlossenen Zustand des Grundmoduls 14, die zu testende elektrische Baugruppe an dem ersten Kontaktierungsabschnitt 20 fixiert. Des Weiteren kann im geschlossenen Zustand des Grundmoduls 14, der erste Kontaktierungsabschnitt 20 dem Fixierungsmodul 22 gegenüberliegen, wobei dazwischen die zu testende elektrische Baugruppen angeordnet werden kann. Im in Figur 1 gezeigten geöffneten Zustand des Grundmoduls 14, wird die zu testende elektrische Baugruppe durch das Fixierungsmodul 22 freigegeben, sodass die elektrische Baugruppe getauscht werden kann.

Zum Testen der elektrischen Baugruppe ist vorgesehen, dass das Schnittstellenmodul 18 mit dem Testmodul 16 elektrisch verbunden ist, sodass die elektrische Baugruppe durch das Testmodul 16 und das Schnittstellenmodul 18 mit der Testvorrichtung 12 elektrisch verbunden ist. In einem nicht beanspruchten Beispiel ist es allerdings auch möglich, das Testmodul 16 direkt, d.h. ohne das Schnittstellenmodul 18, mit der Testvorrichtung 12 elektrisch zu verbinden, sodass das Testen der elektrischen Baugruppe auch ohne Schnittstellenmodul 18 durchgeführt werden kann.

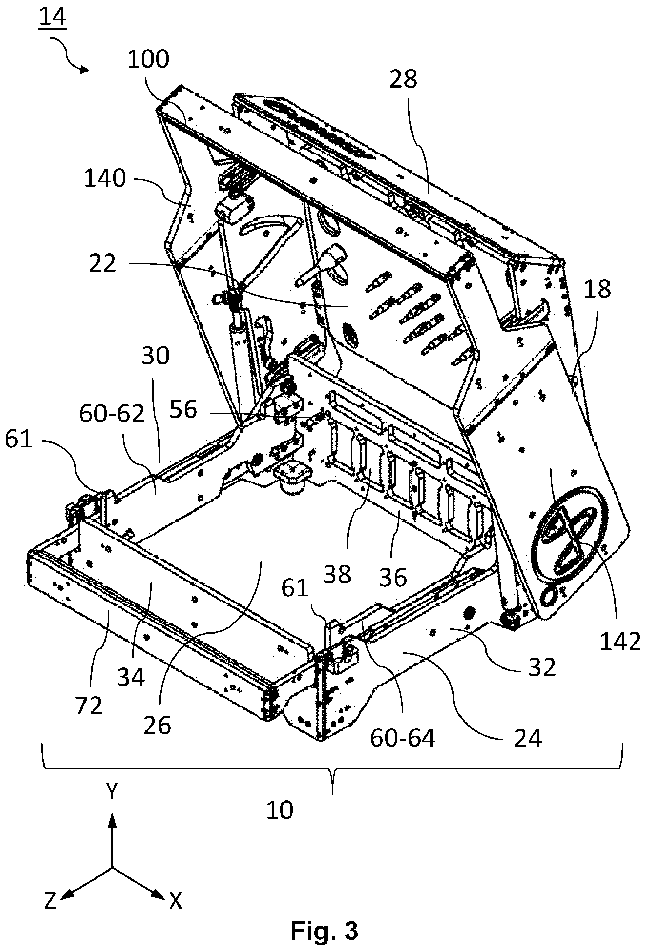

Das Grundmodul 14 weist ferner ein erstes Unterstützungsglied 24 auf, welches einen Aufnahmeraum 26 bereitstellt (siehe Figur 3), in dem das Testmodul 16 angeordnet werden kann. Des Weiteren weist das Grundmodul 14 ein zweites Unterstützungsglied 28 auf, welches relativ zu dem ersten Unterstützungsglied 24 verschwenkbar ist. Dabei ist vorgesehen, dass das Fixierungsmodul 22 lösbar mit dem zweiten Unterstützungsglied 28 verbunden ist. Durch Verschwenken des zweiten Unterstützungsglieds 28 in Bezug auf das erste Unterstützungsglied 24 kann das Grundmodul 14 geschlossen und geöffnet werden.

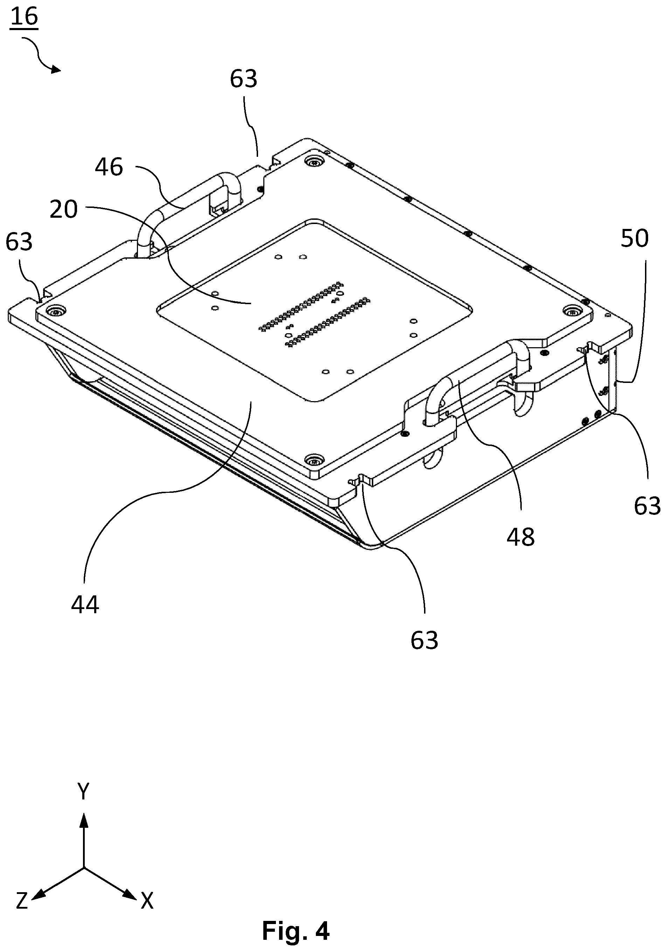

Wie in Figur 3 dargestellt, weist das erste Unterstützungsglied 24 zwei gegenüberliegend angeordnete Seitenwände 30 und 32 auf, welche an einem Ende mit einer Vorderwand 34 des ersten Unterstützungsglied 24 und an dem anderen Ende mit einer Rückwand 36 des ersten Unterstützungsglieds 24 verbunden sind. Das erste Unterstützungsglied 24 bildet somit einen im Wesentlichen rechteckig geformten Rahmen, welcher den Aufnahmeraum 26 für das Testmodul 16 bereitstellt. Im geöffneten Zustand des Grundmoduls 14 kann das in der Figur 4 gezeigte Testmodul 16 von oben in das erste Unterstützungsglied 24 eingesetzt werden bzw. aus dem ersten Unterstützungsglied 24 herausgenommen werden, um das Testmodul 16 auszutauschen. Des Weiteren ist vorgesehen, dass das erste Unterstützungsglied 24 auf einer Auflage, beispielsweise einem Tisch, anordenbar ist.

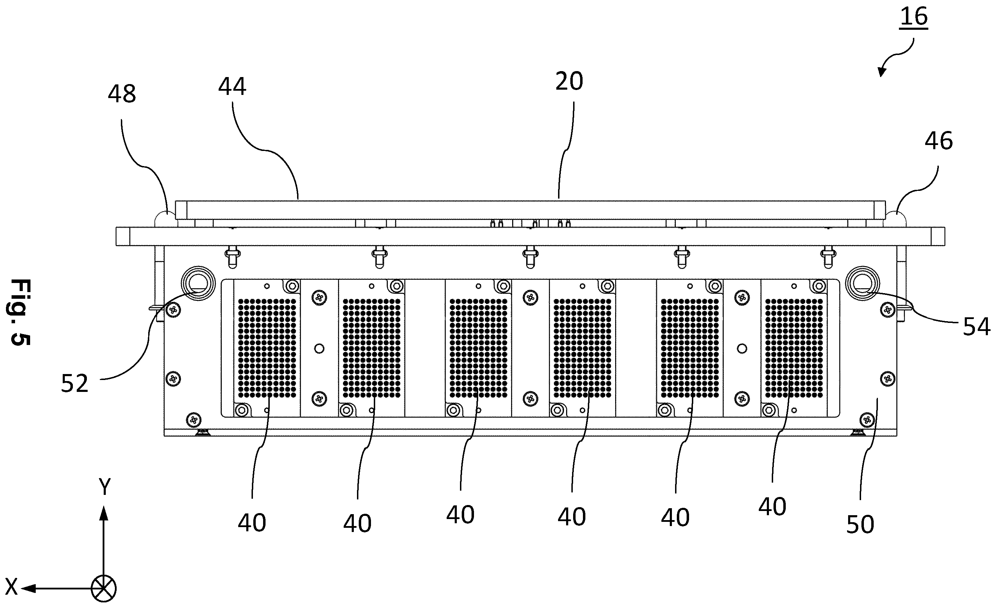

Wie in Figur 3 dargestellt, weist das erste Unterstützungsglied 24 Aussparungen 38 auf, welche in der Rückwand 36 ausgebildet sind. Die Aussparungen 38 ermöglichen es, einen zweiten Kontaktierungsabschnitt 40 (siehe Figur 5) des Testmoduls 16 mit dem Schnittstellenmodul 18 und/oder der Testvorrichtung 12 elektrisch zu verbinden.

Des Weiteren ist das Testmodul 16 beweglich in dem Grundmodul 14 gelagert, und kann relativ zu dem Grundmodul 14 bewegt werden. Insbesondere ist das Testmodul 16 linear geführt und ist zwischen der Vorderwand 34 und der Rückwand 38 hin und her bewegbar.

Figur 4 zeigt in einer perspektivischen Ansicht das Testmodul 16. Das Testmodul 16 weist ein Gehäuse 42 auf, an dessen Oberseite 44 der erste Kontaktierungsabschnitt 20 angeordnet ist. Als Oberseite 44 ist die Seite des Gehäuses 42 zu verstehen, welche im eingesetzten Zustand des Testmoduls 16 in den Aufnahmeraum 26 im Wesentlichen nach oben weist. Dabei wird davon ausgegangen, dass das Grundmodul 14 auf einer im Wesentlichen horizontal verlaufenen Auflage aufgestellt ist. Ferner ist der Oberseite 44 im geschlossenen Zustand des Grundmoduls 14 dem Fixierungsmodul 22 zugewandt. Folglich erstreckt sich die Oberseite 44 bzw. der erste Kontaktierungsabschnitt 20 im Wesentlichen horizontal. Des Weiteren weist das Testmodul 16 zwei Griffe 46 und 48 auf, mit denen das Testmodul 16 aus dem Aufnahmeraum 26 entnommen werden kann und in den Aufnahmeraum 26 eingesetzt werden kann. Die Griffe 46 und 48 sind in dem Testmodul 16 versenkbar und können auf der Oberseite 44 aus dem Testmodul 16 zumindest abschnittsweise herausbewegt werden.

Weiter ist vorgesehen, dass der zweite Kontaktierungsabschnitt 40 an einer Rückseite 50 des Testmoduls 16 angeordnet ist. Im eingesetzten Zustand des Testmoduls 16 in den Aufnahmeraum 26 ist die Rückseite 50 der Rückwand 36 zugewandt. Des Weiteren sind an der Rückseite 50 zwei voneinander beabstandete Öffnungen 52 und 54 (siehe Figur 5) vorgesehen, in welche durch Bewegen des Testmoduls 16 in Bezug auf das erste Unterstützungsglied 24 korrespondierende Bolzen 56 und 58 (siehe Figur 3) einführbar sind. Die Bolzen 56 und 58 sind an der Rückwand 36 angeordnet und erstrecken sich im Wesentlichen in Richtung der Vorderwand 34. Mit anderen Worten, die Bolzen 56 und 58 sind im Wesentlichen senkrecht an der Rückwand 36 ausgebildet. Mittels der Bolzen 56 und 58 und Öffnungen 52 und 54 ist es möglich, dass Testmodul 16 in dem Aufnahmeraum 26 physisch zu verriegeln, indem das Testmodul 16 auf die Bolzen 56 und 58 geschoben wird bzw. schiebbar ist.

Zum Bewegen des Testmoduls 16 in dem Grundmodul 14 kann ein Aufnahmeglied 60 (siehe Figur 3) vorgesehen sein, welches in Bezug auf das erste Unterstützungsglied 24 beweglich ausgebildet ist. Ferner ist vorgesehen, dass das Testmodul 16 in das Aufnahmeglied 60 eingesetzt wird bzw. auf das Aufnahmeglied 60 gesetzt wird, wobei das Testmodul 16 an dem Aufnahmeglied 60 fixiert ist. Zum Fixieren des Testmoduls 16 an dem Aufnahmeglied 60 kann das Aufnahmeglied 60 beispielsweise Vorsprünge 61 aufweisen, welche in entsprechende Ausbuchtungen 63 des Testmoduls eingreifen, wenn das Testmodul 16 an dem Aufnahmeglied 60 angeordnet ist. Somit wird eine horizontale Bewegung des Testmoduls 16 in Bezug auf das Aufnahmeglied 60 verhindert.

Insbesondere ist das Aufnahmeglied 60 an dem ersten Unterstützungsglied 24 derart beweglich gelagert, dass es zwischen der Vorderwand 34 und Rückwand 36 linear führbar ist. Das Aufnahmeglied 60 weist ferner ein erstes Aufnahmeelement 62 und ein zweites Aufnahmeelement 64 auf, welche gegenüberliegend angeordnet sind, wobei das Testmodul 16 im eingesetzten Zustand zwischen dem ersten Aufnahmeelement 62 und dem zweiten Aufnahmeelement 64 angeordnet ist. Ferner weißen das erste Aufnahmeelement 62 und das zweite Aufnahmeelement 64 jeweils mindestens zwei der zuvor genannten Vorsprünge 61 auf. Ferner ist das erste Aufnahmeelement 62 der Seitenwand 30 des ersten Unterstützungsglieds 24 zugeordnet und das zweite Aufnahmeelement 64 der Seitenwand 32 des ersten Unterstützungsglieds 24 zugeordnet.

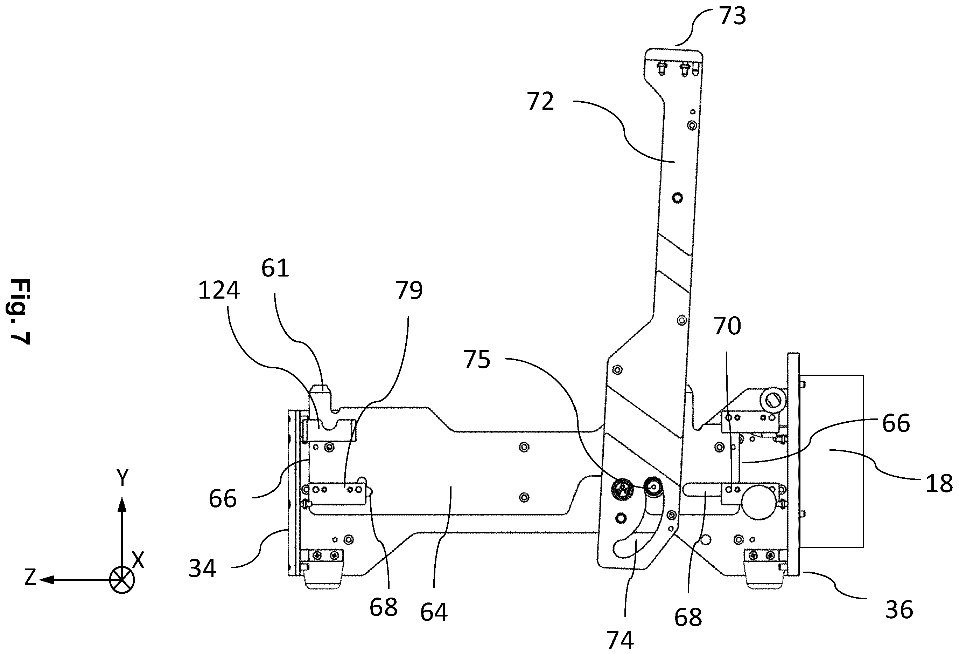

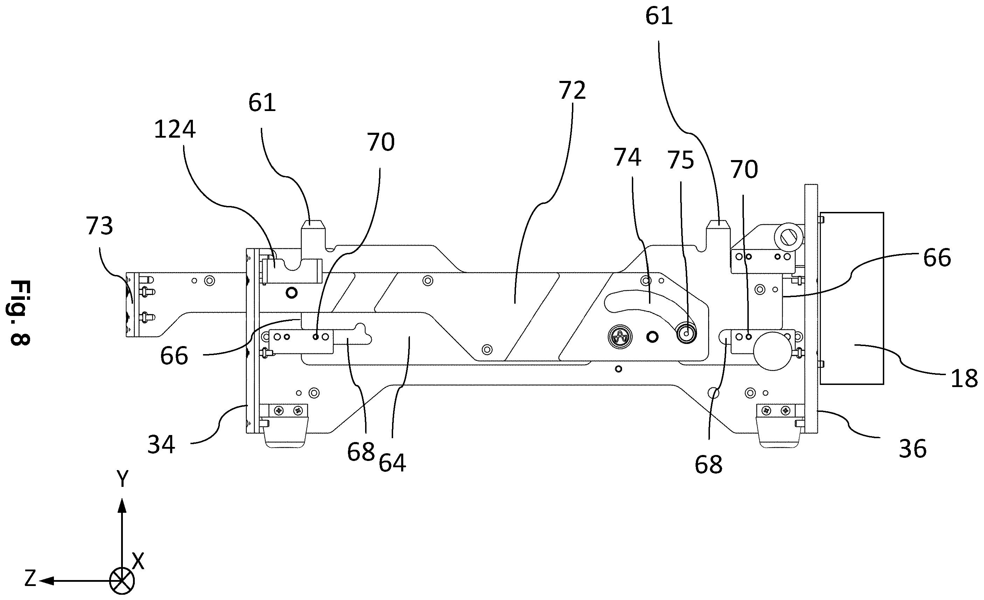

Wie in den Figuren 7 und 8 gezeigt, weisen das erste Aufnahmeelement 62 und das zweite Aufnahmeelement 64 jeweils an ihren in horizontaler Richtung liegenden Enden 66 im Wesentlichen horizontal verlaufende Aussparungen 68 auf, mittels derer das erste Aufnahmeelement 62 und das zweite Aufnahmeelement 64 auf an dem ersten Unterstützungsglied 24 angeordneten Lagerelementen 70 in horizontaler Richtung beweglich gelagert sind. Es ist anzumerken, dass in den Figuren 7 und 8 das erste Aufnahmeelement 62 verdeckt ist, da es sich um eine Seitenansicht handelt. Ferner werden in den Figuren 7 und 8 zum Zweck einer besseren Verständlichkeit nur die wichtigsten Elemente gezeigt und insbesondere das zweite Unterstützungsglied 28 weggelassen.

Wie aus den Figuren 7 und 8 weiter ersichtlich, ist es möglich, das erste Aufnahmeelement 62 und das zweite Aufnahmeelement 64 in einer Bewegungsebene hin und her zu bewegen. Die Bewegungsebene verläuft beim bestimmungsgemäßen Gebrauch des Testsystems im Wesentlichen horizontal, d.h., das erste Aufnahmeelement 62 und das zweite Aufnahmeelement 64 sind in Richtung der Vorderwand 34 und in Richtung der Rückwand 36 hin und her bewegbar. Bevorzugt sind das erste Aufnahmeelement 62 und das zweite Aufnahmeelement 64 ausschließlich in der Bewegungsebene bewegbar.

Zum Bewegen des Testmoduls 16 bzw. des Aufnahmeglieds 60 kann an dem Grundmodul 14 eine erste Bedieneinheit 72 vorgesehen sein (siehe Figur 1). Die erste Bedieneinheit 72 ist in Bezug auf das erste Unterstützungsglied 24 verschwenkbar und kann von einer Verriegelungsposition (siehe Figur 8), in der das Testmodul 16 in dem Grundmodul 14 verriegelt ist, in eine Entriegelungsposition (siehe Figur 7), in der das Testmodul 16 in dem Grundmodul 14 entriegelt ist, verschwenkt werden. Die erste Bedieneinheit 72 kann insbesondere verschwenkbar an dem ersten Unterstützungsglied 24 angeordnet sein. Die erste Bedieneinheit 72 kann ferner einen Griff 73 aufweisen, mittels dessen die erste Bedieneinheit 72 durch einen Nutzer gegenüber dem ersten Unterstützungsglied 24 verschwenkt werden kann.

Ferner kann die erste Bedieneinheit 72 im geschlossenen Zustand des Grundmoduls 14 nur die Verriegelungsposition einnehmen. Dagegen kann im geöffneten Zustand des Grundmoduls 14, die erste Bedieneinheit 72 sowohl die Verriegelungsposition als auch die Entriegelungsposition einnehmen. Ein Entriegeln des Testmoduls 16 ist somit nur im geöffneten Zustand des Grundmoduls 14 möglich. Zum Bewegen des Aufnahmeglieds 60 weist die erste Bedieneinheit 72 für das erste Aufnahmeelement 62 und das zweite Aufnahmeelement 64 jeweils eine erste Kulissenführung 74 auf. Die erste Bedieneinheit 72 kann im Wesentlichen U-förmig ausgebildet sein und zwei gegenüberliegende Schenkel 75 aufweisen, die durch den Griff 73 verbunden sind. Ferner ist in jedem Schenkel 75 eine erste Kulissenführung 74 ausgebildet und die Schenkel 75 sind jeweils derart an dem ersten Unterstützungsglied 14 angeordnet, dass die erste Bedieneinheit 72 in Bezug auf das erste Unterstützungsglied 24 verschwenkbar ist. Ferner weisen jeweils das erste Aufnahmeelement 62 und das zweite Aufnahmeelement 64 ein erstes Nockenelement 71 auf, welche jeweils in der entsprechenden Kulissenführungen 74 führbar gelagert sind. Ferner ist vorgesehen, dass die erste Kulissenführung 74 einen geschwungenen Verlauf aufweist, sodass durch Bewegen der ersten Bedieneinheit 72 von der Verriegelungsposition in die Entriegelungsposition, das in dem Aufnahmeglied 60 angeordnete Testmodul 16 in Richtung der Vorderwand 34 geführt wird. Beim Bewegen der ersten Bedieneinheit 72 von der Entriegelungsposition in die Verriegelungsposition wird das Testmodul 16 in die entgegengesetzte Richtung, in Richtung der Rückwand 36, bewegt. Ferner ist vorgesehen, dass in der Entriegelungsposition die Bolzen 56 und 58 nicht oder nur minimal in die Öffnungen 52 und 54 eingreifen. In der Verriegelungsposition dagegen wird das Testmodul 16 auf die Bolzen 56 und 58 geschoben, sodass die Bolzen 56 und 58 in die Öffnungen 52 bzw. 54 eingreifen.

Wie oben erwähnt ist der zweite Kontaktierungsabschnitt 40 des Testmoduls 16 dazu ausgebildet, dass Schnittstellenmodul 18 elektrisch zu kontaktieren. Dazu kann das Schnittstellenmodul 18 einen in Figur 1 gezeigten entsprechenden grundmodulseitigen Kontaktierungsabschnitt 76 aufweisen, der mit dem zweiten Kontaktierungsabschnitt 40 des Testmoduls 16 elektrisch verbindbar ist. Es kann vorgesehen sein, dass das Schnittstellenmodul 18 derart an dem Grundmodul 14 angeordnet ist, dass im verriegelten Zustand des Testmoduls 16 in dem Grundmodul 14 der grundmodulseitige Kontaktierungsabschnitt 76 dem zweiten Kontaktierungsabschnitts 40 gegenüberliegend angeordnet ist. Das Schnittstellenmodul 18 ist an der Außenseite der Rückwand 36 angeordnet (siehe Figur 8). Des Weiteren ist vorgesehen, dass das Schnittstellenmodul 18 lösbar mit dem Grundmodul 14 verbunden ist, sodass das Schnittstellenmodul 18 einfach ausgetauscht werden kann.

Der zweite Kontaktierungsabschnitt 40 und der grundmodulseitige Kontaktierungsabschnitt 76 können als Pylonstecker ausgebildet sein, um sich gegenseitig elektrisch zu kontaktieren. In der Verriegelungsposition des Testmoduls 16 ist vorgesehen, dass der zweite Kontaktierungsabschnitt 40 den grundmodulseitigen Kontaktierungsabschnitt 76 elektrisch kontaktiert. Durch Bewegen der Bedieneinheit ersten 72 in die Entriegelungsposition erfährt das Testmodul 16 eine Relativbewegung in Bezug auf das Schnittstellenmodul 18 derart, dass das Testmodul 16 von dem Schnittstellenmodul 18 fortbewegt wird, wodurch das Testmodul 16 von dem Schnittstellenmodul 18 elektrisch und/oder physisch getrennt wird. Insbesondere wird die elektrische Verbindung des zweiten Kontaktierungsabschnitts 40 und des grundmodulseitigen Kontaktierungsabschnitts 76 getrennt. Umgekehrt wird beim Bewegen der ersten Bedieneinheit 72 von der Entriegelungsposition in die Verriegelungsposition der zweite Kontaktierungsabschnitt 40 mit dem grundmodulseitigen Kontaktierungsabschnitt 76 elektrisch verbunden.

Ferner kann vorgesehen sein, dass der erste Kontaktierungsabschnitt 20 mit dem zweiten Kontaktierungsabschnitt 40 zumindest teilweise, bevorzugt vollständig, durch Wire-Wrapping miteinander elektrisch verbunden ist. Insbesondere sind die in dem Testmodul 16 innenliegenden Kontaktpins des ersten Kontaktierungsabschnitts 20 und des zweiten Kontaktierungsabschnitts 40 mittels Wire-Wrapping miteinander elektrisch verbunden. Ebenso kann vorgesehen sein, dass die in dem Schnittstellenmodul 18 innenliegenden Kontaktpins des grundmodulseitigen Kontaktierungsabschnitts 76 mittels Wire-Wrapping mit einem testvorrichtungsseitigen Kontaktierungsabschnitt (nicht gezeigt) des Schnittstellenmoduls 18 elektrisch verbunden sind. Mittels des testvorrichtungsseitigen Kontaktierungsabschnitts ist es ferner möglich, die Testverrichtung 12 elektrisch mit dem Schnittstellenmodul 18 zu verbinden.

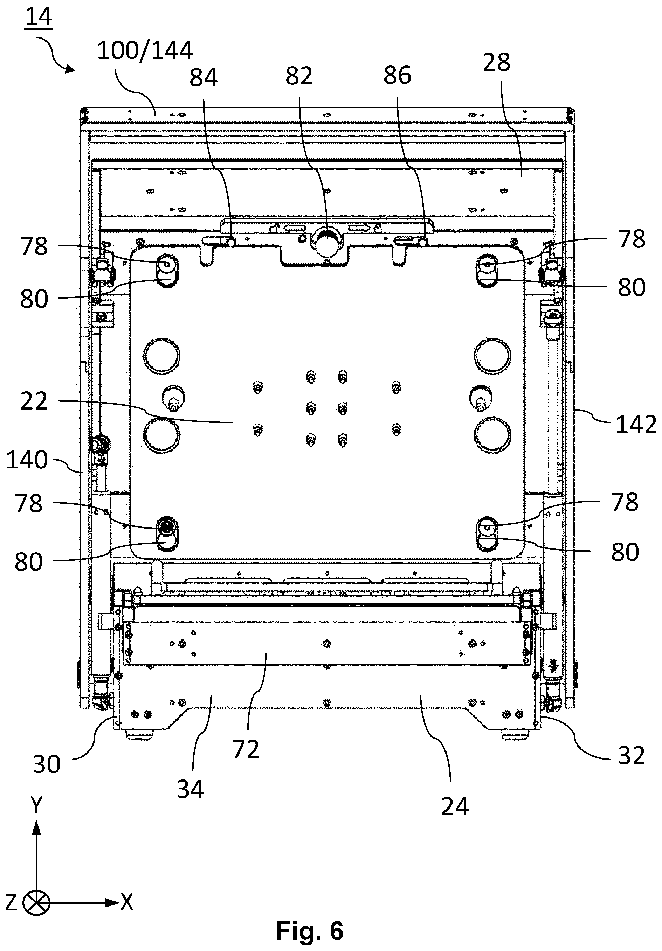

Wie oben erwähnt weist das Grundmodul 14 ein mit dem Grundmodul 14 kuppelbares Fixierungsmodul 22 auf. Das Kuppeln des Fixierungsmoduls 22 mit dem Grundmodul 14 wird im Folgenden unter Bezugnahme auf die Figur 6 näher erläutert. Wie in Figur 6 dargestellt, ist das Fixierungsmodul 22 im Wesentlichen flach und plattenförmig ausgebildet. Ferner ist das Fixierungsmodul 22 derart an dem zweiten Unterstützungsglied 28 anordenbar, dass im geschlossenen Zustand des Grundmoduls 14, das Fixierungsmodul 22 dem ersten Kontaktierungsabschnitt 20 gegenüberliegend und bevorzugt parallel zu dem ersten Kontaktierungsabschnitt 20 angeordnet ist. Des Weiteren weist das zweite Unterstützungsglied 28 mehrere Aufnahmepunkte 78 auf, mittels derer das Fixierungsmodul 22 über entsprechende Aufnahmeöffnungen 80, welche an dem Fixierungsmodul 22 ausgebildet sind, an dem zweiten Unterstützungsglied 28 schwimmend lagerbar ist. Die Aufnahmeöffnungen 80 können beispielsweise als Schlüssellochöffnungen ausgebildet sein, wobei die Aufnahmepunkte 78 durch die entsprechenden Aufnahmeöffnungen 80 hindurchführbar sind.

Des Weiteren weist das zweite Unterstützungsglied 28 eine Verriegelung 82 auf, mittels derer die Verriegelungselemente 84 und 86 in eine Verriegelungsposition und in eine Entriegelungsposition bewegbar sind. In der Verriegelungsposition fixieren die Verriegelungselemente 84 und 86 das Fixierungsmodul 22 derart an dem zweiten Unterstützungsglied 28, dass das Fixierungsmodul 22 von den Aufnahmepunkten 78 nicht gelöst werden kann. In der Entriegelungsposition der Verriegelungselemente 84 und 86 ist das Fixierungsmodul 22 in Bezug auf das zweite Unterstützungsglied 28 bewegbar, sodass das Fixierungsmodul 22 von den Aufnahmepunkten 78 gelöst werden kann. Somit kann auf einfache Weise ein Wechsel des Fixierungsmoduls 22 vorgenommen werden.

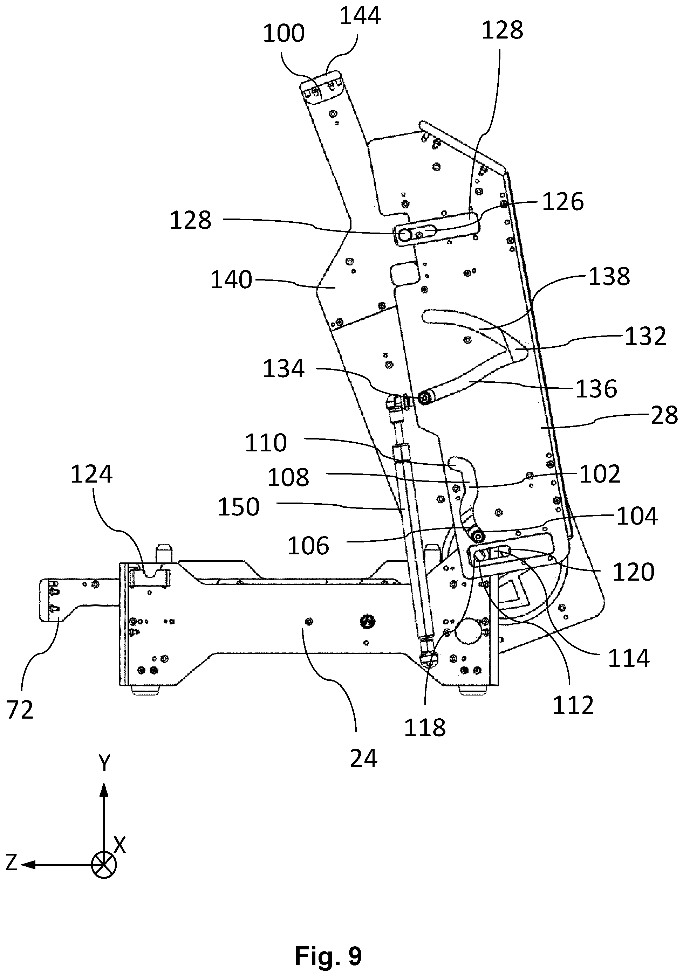

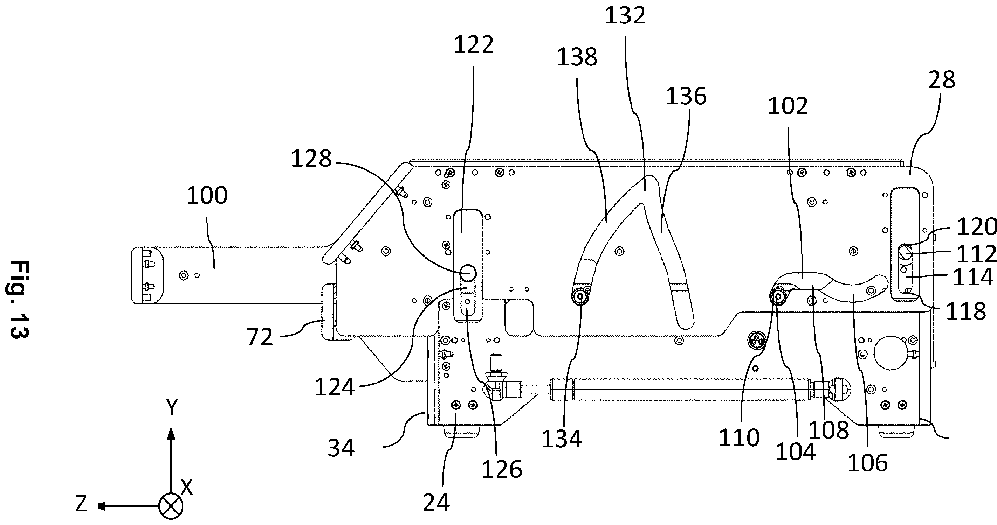

Ferner weist das Grundmodul 14 wie in Figur 1 dargestellt, eine relativ zu dem ersten Unterstützungsglied 24 verschwenkbar gelagerte zweite Bedieneinheit 100 auf. Durch Bewegen bzw. Verschwenken der zweiten Bedieneinheit 100 in Bezug auf das erste Unterstützungsglied kann das Grundmodul 14 geöffnet und geschlossen werden. Insbesondere ist die zweite Bedieneinheit 100 an dem ersten Unterstützungsglied 24 verschwenkbar gelagert angeordnet, sodass die zweite Bedieneinheit 100 in Bezug auf das erste Unterstützungsglied 24 bewegbar ist. Durch Verschwenken der zweiten Bedieneinheit 100 gegenüber dem ersten Unterstützungsglied 24 ist das zweite Unterstützungsglied 28 in eine Öffnungsposition bewegbar (siehe Figur 9), in der die zu testende elektrische Baugruppe durch das Fixierungsmodul 22 freigegeben ist und somit austauschbar ist. Ferner kann durch Verschwenken der zweiten Bedieneinheit 100 gegenüber dem ersten Unterstützungsglied 24 das zweite Unterstützungsglied 28 in eine Verschlussposition (siehe Figur 2 und 13) bewegt werden, in der die zu testende elektrische Baugruppe durch das Fixierungsmodul 22 an dem Testmodul 16 fixiert ist. Ferner ist das Grundmodul 14 in der Verschlussposition geschlossen und in der Öffnungsposition geöffnet.

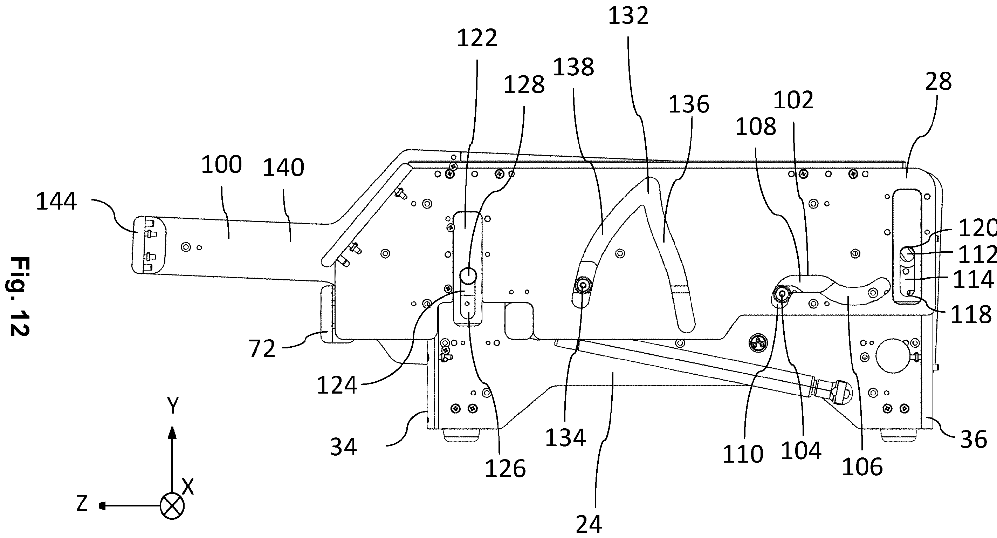

Bezugnehmend auf die Figuren 1 und 9-13 wird im Folgenden das Öffnen und Schließen des Grundmoduls 14 erläutert. Das zweite Unterstützungsglied 28 ist an dem ersten Unterstützungsglied 24 verschwenkbar gelagert, um in Bezug auf das erste Unterstützungsglied 24 bewegbar zu sein. Des Weiteren weist das zweite Unterstützungsglied 28 eine zweite Kulissenführung 102 auf, in der ein an der zweiten Bedieneinheit 100 angeordnetes zweites Nockenelement 104 entlang führbar ist. Die zweite Kulissenführung 102 weist ferner einen geschwungenen Abschnitt 106, einen sich an den geschwungenen Abschnitt 106 anschließenden ersten linearen Abschnitt 108 und einen sich an den ersten linearen Abschnitt 108 anschließenden zweiten linearen Abschnitt 110 auf. Um das zweite Unterstützungsglied 28 von der Öffnungsposition in die Verschlussposition zu bewegen, wird durch Verschwenken der zweiten Bedieneinheit 100 das zweite Nockenelement 104 den geschwungenen Abschnitt 106, den ersten linearen Abschnitt 108 und den zweiten linearen Abschnitt 110 entlanggeführt (in dieser Reihenfolge). Insbesondere wird das zweite Nockenelement 104 vollständig entlang der zweiten Kulissenführung 102 entlanggeführt.

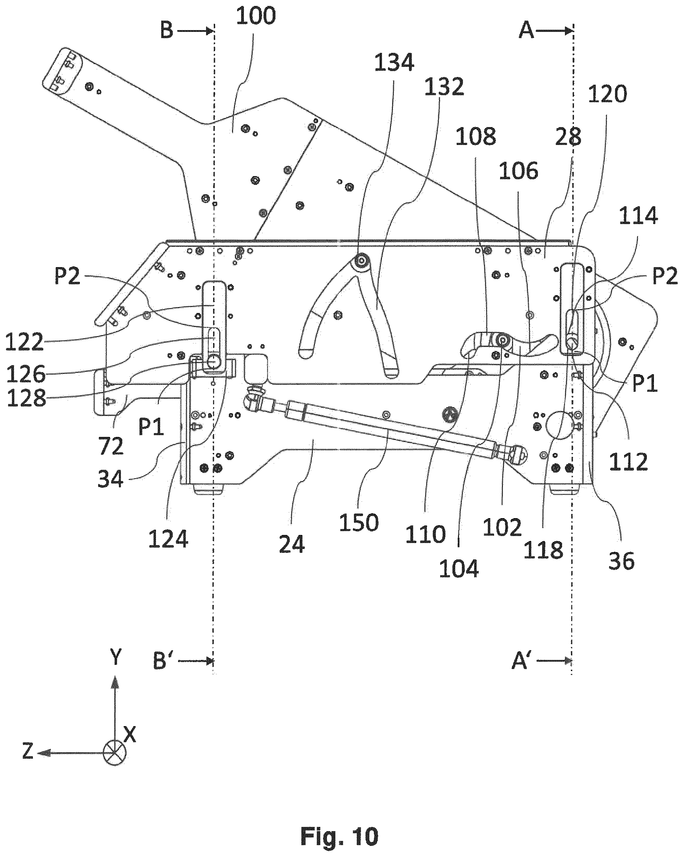

Wie aus den Figuren 9 und 10 ersichtlich wird durch Entlangführen des zweiten Nockenelements 104 in dem geschwungenen Abschnitt 106 der zweiten Kulissenführung 102, das zweite Unterstützungsglied 28 in Bezug auf das erste Unterstützungsglied 24 verschwenkt, sodass beim Übergang des zweiten Nockenelements von dem geschwungenen Abschnitts 106 in den ersten linearen Abschnitt 108, das Testmodul 16 und das Fixierungsmodul 22 im Wesentlichen gegenüberliegend angeordnet sind. Das Entlangführen des zweiten Nockenelements 104 an dem geschwungenen Abschnitt 106 bzw. das Verschwenken des zweiten Unterstützungsglieds 28 in Bezug auf das erste Unterstützungsglied 24 wird als erste Bewegungsphase bezeichnet. Die erste Bewegungsphase endet, wenn das zweite Nockenelement 104 von dem geschwungenen Abschnitt 106 in den ersten linearen Abschnitt 108 übergeht.

Durch fortsetzen des Verschwenkens der zweiten Bedieneinheit 100 bzw. herunterdrücken der zweiten Bedieneinheit 100 in Richtung des ersten Unterstützungsglieds 24, wird das zweite Nockenelement 104 den ersten linearen Abschnitt 108 und bevorzugt den zweiten linearen Abschnitt 110 entlanggeführt, wodurch ein Absenken des zweiten Unterstützungsglieds 28 in Richtung des ersten Unterstützungsglieds 24 erfolgt. Insbesondere erfolgt das Absenken des zweiten Unterstützungsglieds 28 in Richtung des ersten Unterstützungsglieds 24 durch eine linear geführte Bewegung des zweiten Unterstützungsglieds 28. Das Entlangführen des zweiten Nockenelements 104 an dem ersten linearen Abschnitt 108 und an dem zweiten linearen Abschnitt 110 wird als zweite Bewegungsphase bezeichnet, welche durch die linear geführte Bewegung des zweiten Unterstützungsglieds 28 in Richtung des ersten Unterstützungsglieds 24 gekennzeichnet ist. Unter einer linear geführten Bewegung des zweiten Unterstützungsglieds 28 in Richtung des ersten Unterstützungsglieds 24 wird eine Bewegung verstanden, bei der der Normalenvektor des Fixierungsmoduls 22 im Wesentlichen parallel zu dem Normalenvektor des Testmoduls 16 verläuft. Der Normalenvektor des Fixierungsmoduls 22 ist dabei auf die Seite des Fixierungsmoduls 22 bezogen, welche im geschlossenen Zustand des Grundmoduls 14 dem Testmodul 16 zugewandt ist. Des Weiteren ist der Normalenvektor des Testmoduls 16 dabei auf die Seite des Testmoduls 16 bezogen, welche im geschlossenen Zustand des Grundmoduls 14 dem Fixierungsmodul 22 zugewandt ist.

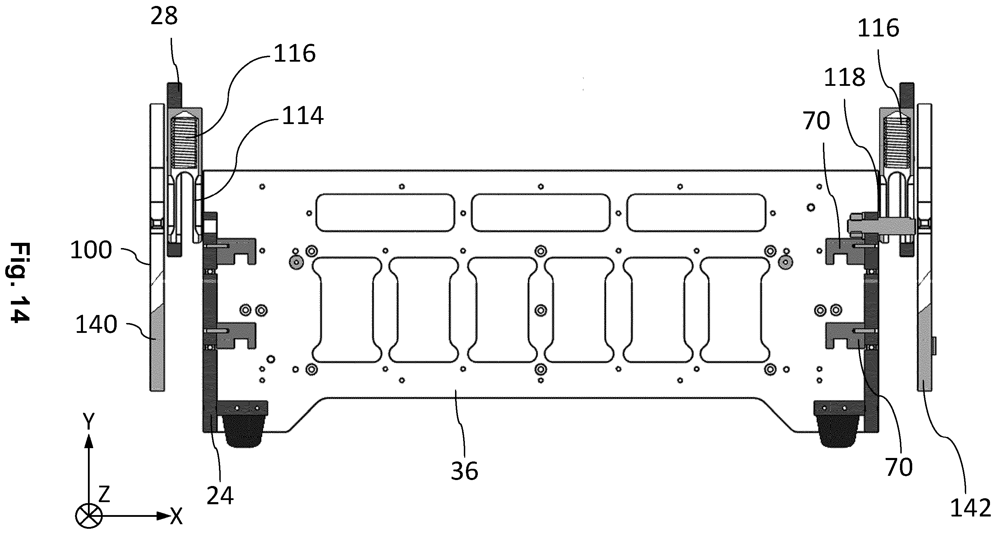

Zur Unterstützung der linear geführten Bewegung des zweiten Unterstützungsglieds 28 in Richtung des ersten Unterstützungsglieds 24, kann das zweite Unterstützungsglied 28 an dem ersten Unterstützungsglied 24 federnd gelagert sein. Insbesondere kann das zweite Unterstützungsglied 28 an einem Aufnahmepunkt 112 des ersten Unterstützungsglieds 24 verschwenkbar und gefedert angeordnet ist. Dazu kann das zweite Unterstützungsglied 28 mittels eines ersten Langlochs 114 an dem Aufnahmepunkt 112 des ersten Unterstützungsglieds 24 verschwenkbar in Bezug auf das erste Unterstützungsglied 24 gelagert sein. Dabei ist in dem ersten Langloch 114 ein Federelement 116 angeordnet, welches derart auf den Aufnahmepunkt 116 wirkt, dass der Aufnahmepunkt 116 an einem ersten Ende 118 des ersten Langlochs 114 liegt. Figur 14 zeigt einen Querschnitt durch das Grundmodul 14 entlang der in Figur 10 gezeigten Schnittebene A-A'. Dabei zeigt Figur 14 das erste Langloch 114 in dem das Federelement 116 angeordnet ist, welches auf den Aufnahmepunkt 112 wirkt.

Während der ersten Bewegungsphase wird der Aufnahmepunkt 112 durch das Federelement 116 des ersten Langlochs an dem ersten Ende 118 des Langlochs 114 gehalten. Ferner verlagert sich mit dem Einsetzen der zweiten Bewegungsphase der Aufnahmepunkt 112 in Richtung des zweiten Endes 120 des Langlochs 114, sodass zum Ende der zweiten Bewegungsphase der Aufnahmepunkt 112 am zweiten Ende 120 des Langlochs 118 liegt. Das zweite Unterstützungsglied 28 kann somit auf vorteilhafte Weise einfach an dem Aufnahmepunkt 112 des ersten Unterstützungsglieds 24 federnd gelagert und verschwenkbar ausgebildet sein.

Ferner kann das zweite Unterstützungsglied 28 einen federgelagerten Anschlag 122 aufweisen, der beim Bewegen des zweiten Unterstützungsglieds 28 von der Öffnungsposition in die Verschlussposition auf ein an dem ersten Unterstützungsglied 24 angeordneten Auflagerpunkt 124 geführt wird. Ferner kontaktiert der federgelagerte Anschlag 122 erst mit Beginn der zweiten Bewegungsphase den Auflagerpunkt 124 des ersten Unterstützungsglieds 24. Der federgelagerte Anschlag 122 kann ferner eine erste Anschlagposition P1, siehe Figur 10, und eine zweite Anschlagposition P2, siehe Figur 13, aufweisen, wobei während der ersten Bewegungsphase der federgelagerte Anschlag 122 die erste Anschlagposition P1 aufweist und während der zweiten Bewegungsphase in die zweite Anschlagposition P2 bewegt wird. Mit anderen Worten, zu Beginn der zweiten Bewegungsphase ist der federgelagerte Anschlag 122 in der ersten Anschlagposition P1 und am Ende der zweiten Bewegungsphase in der Anschlagposition P2. Ferner entspricht das Bewegen des federgelagerten Anschlags 122 von der ersten Anschlagposition P1 in die zweite Anschlagposition P2 einem Einfedern des federgelagerten Anschlags 122.

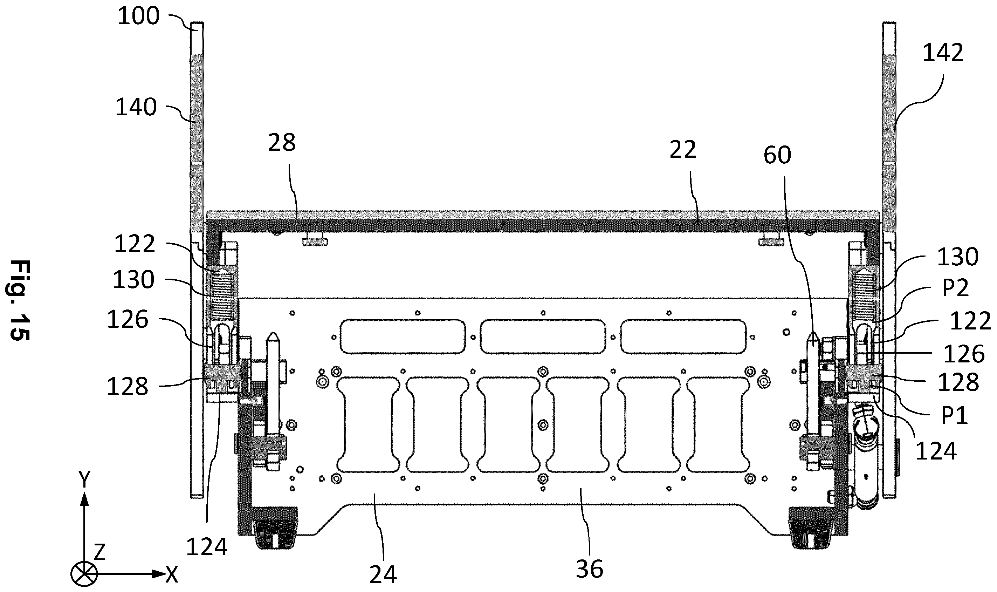

Ferner kann der federgelagerte Anschlag 122 ein zweites Langloch 126 aufweisen, in welchem ein Anschlagelement 128 federgelagert ist und welches zwischen den beiden Enden des zweiten Langlochs 126 bzw. der ersten Anschlagposition P1 und zweiten Anschlagposition P2 bewegbar ist. Figur 15 zeigt einen Querschnitt durch das Grundmodul 14 entlang der in Figur 10 gezeigten Schnittebene B-B'. Dabei zeigt Figur 15 das zweite Langloch 126 in dem ein Federelement 130 angeordnet ist, welches auf das Anschlagelement 128 wirkt. Zu Beginn der zweiten Bewegungsphase ist das Anschlagelement 128 in der ersten Anschlagposition P1 und am Ende der zweiten Bewegungsphase in der Anschlagposition P2.

Während der zweiten Bewegungsphase werden der federgelagerte Anschlag 122 und die Federlagerung des zweiten Unterstützungsglieds 28 an dem Aufnahmepunkt 112 des ersten Unterstützungsglieds 24 gleichmäßig betätigt, wodurch ein gleichmäßiges Absenken, insbesondere lineares Absenken, des zweiten Unterstützungsglieds 28 auf das erste Unterstützungsglied 24 erfolgt. Folglich wird auch das Fixierungsmodul 22 linear auf das Testmodul 16 abgesenkt.

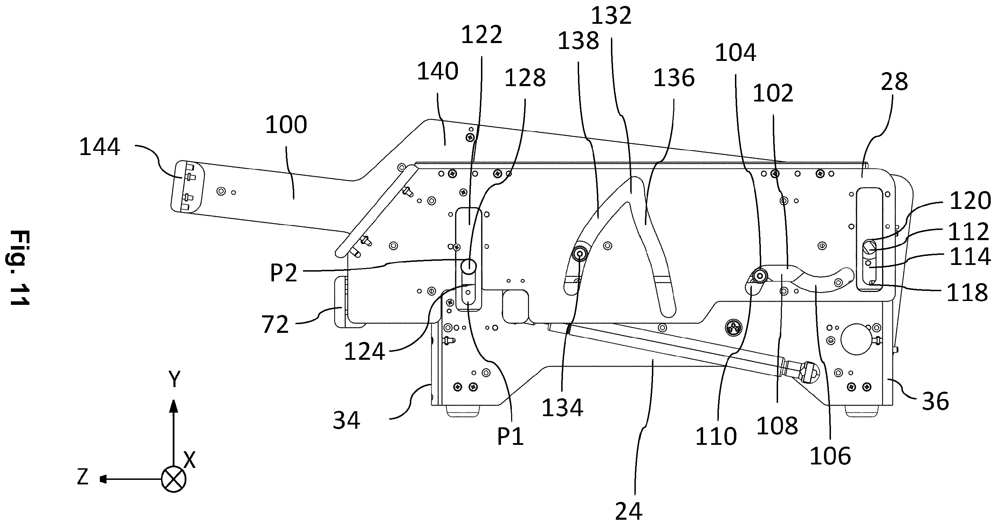

Vorzugsweise ist der zweite lineare Abschnitt 110 in Bezug auf den ersten linearen Abschnitt 108 abgewinkelt. Insbesondere verläuft der erste lineare Abschnitt 108 zu Beginn der zweiten Bewegungsphase im Wesentlichen parallel zu einer von der Oberseite 44 des Testmoduls 16 aufgespannten Ebene. Ferner weist der zweite lineare Abschnitt 110 zu Beginn der zweiten Bewegungsphase ausgehend von dem ersten linearen Abschnitt 108 in Richtung des ersten Unterstützungsglieds 24. Beim Übergang des zweiten Nockenelements 104 vom ersten linearen Abschnitt 108 in den zweiten linearen Abschnitt 110 wird das zweite Unterstützungsglied 28 durch die Federlagerung des zweiten Unterstützungsglieds 28 an dem ersten Unterstützungsglied 24 von dem ersten Unterstützungsglied 24 weggedrückt. Anschließend wird durch Entlangfahren des zweiten Nockenelements 104 in dem zweiten linearen Abschnitt 110 das zweite Unterstützungsglied 28 wieder in Richtung des ersten Unterstützungsglieds 24 bewegt. Durch den Übergang des zweiten Nockenelements 104 in den zweiten linearen Abschnitt 110 arretiert das zweite Unterstützungsglied 28 somit die zweite Bedieneinheit 100, sodass die zweite Bedieneinheit 100 nicht selbstständig verschwenkt werden kann. Insbesondere wird die zweite Bedieneinheit 100 durch das zweite Unterstützungsglied 28 arretiert, wenn das zweite Nockenelement 104 in dem zweiten linearen Abschnitt 110 unter das Niveau des ersten linearen Abschnitts 108 fällt (siehe Figuren 11-13).

Das zweite Unterstützungsglied 28 kann ferner eine dritte Kulissenführung 132 aufweisen, in der ein drittes Nockenelement 134 der zweiten Bedieneinheit 100 führbar gelagert ist. Die dritte Kulissenführung 132 kann insbesondere dazu ausgebildet sein, während einem Verschwenken der zweiten Bedieneinheit 100, das zweite Unterstützungsglied 28 in Bezug auf das erste Unterstützungsglied 24 zu stabilisieren. Die dritte Kulissenführung 132 weist einen ersten Abschnitt 136 auf, an den sich ein zweiter Abschnitt 138 anschließt, wobei der zweite Abschnitt 138 gegenüber dem ersten Abschnitt 136 abgewinkelt ist. Ferner wird das dritte Nockenelements 134 während der ersten Bewegungsphase an dem ersten Abschnitt 136 entlanggeführt und während der zweiten Bewegungsphase entlang des zweiten Abschnitts 138 entlanggeführt.

Die zweite Bedieneinheit 100 kann U-förmig ausgebildet sein und zwei gegenüberliegende Seitenabschnitte 140 und 142 aufweisen, welche an einem Ende durch einen Griff 144 miteinander verbunden sind. Im geschlossenen Zustand des Grundmoduls 14 ist der Griff 144 der zweiten Bedieneinheit 100 an der Vorderseite des Grundmoduls 14 angeordnet. Die Seitenabschnitte 140 und 142 sind jeweils seitlich außenliegend an dem Grundmodul 14 angeordnet und können jeweils ein zweites Nockenelement 104 und ein drittes Nockenelement 134 aufweisen. Ferner ist die zweite Bedieneinheit 100 an den offenen Enden der Seitenabschnitte 140 und 142 schwenkbar mit dem ersten Unterstützungsglied 24 verbunden. Insbesondere kann der Seitenabschnitt 140 an der Seitenwand 30 des ersten Unterstützungsglieds 24 verschwenkbar angeordnet sein und der Seitenabschnitt 142 an der Seitenwand 32 des ersten Unterstützungsglieds 24 verschwenkbar angeordnet sein.

Ferner weist das zweite Unterstützungsglied 28 zwei gegenüberliegende Seitenelemente 146 und 148 auf, welche jeweils eine zweite Kulissenführung 102 und ein dritte Kulissenführung 132 aufweisen. Ferner kann das Seitenelement 146 des zweiten Unterstützungsglieds 28 an der Seitenwand 30 des ersten Unterstützungsglieds 24 verschwenkbar angeordnet, wobei die Seitenwand 30 hierzu den Aufnahmepunkt 112 vorsieht. Ebenso ist das Seitenelement 148 des zweiten Unterstützungsglieds 28 an der Seitenwand 32 des ersten Unterstützungsglieds 24 verschwenkbar angeordnet, wobei hierzu die Seitenwand 32 ebenfalls einen Aufnahmepunkt 112 vorsieht. Ferner weist jedes Seitenelement 146 und 148 des zweiten Unterstützungsglieds 28 ein erstes Langloch 114 und einen federgelagerten Anschlag 122 auf. In einer Draufsicht auf das geschlossenen Grundmoduls 14 weist das zweite Unterstützungsglied 28 eine im Wesentlichen rechteckige Form auf, wobei durch die federgelagerten Anschläge 122 und Langlöcher 114 das zweite Unterstützungsglied 28 an vier Punkten an dem ersten Unterstützungsglied 24 federgelagert ist.

Des Weiteren ist ein Federunterstützungselement 150 vorgesehen, welches das zweite Unterstützungsglied 28 mit dem ersten Unterstützungsglied 24 verbindet. Das Federunterstützungselement 150 kann beispielsweise ein Gasdruckfederelement sein.

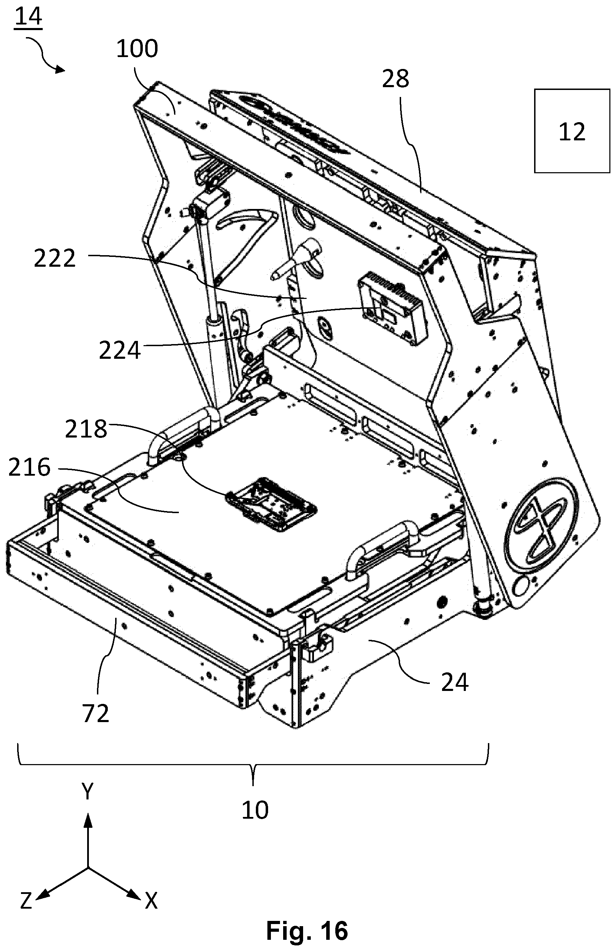

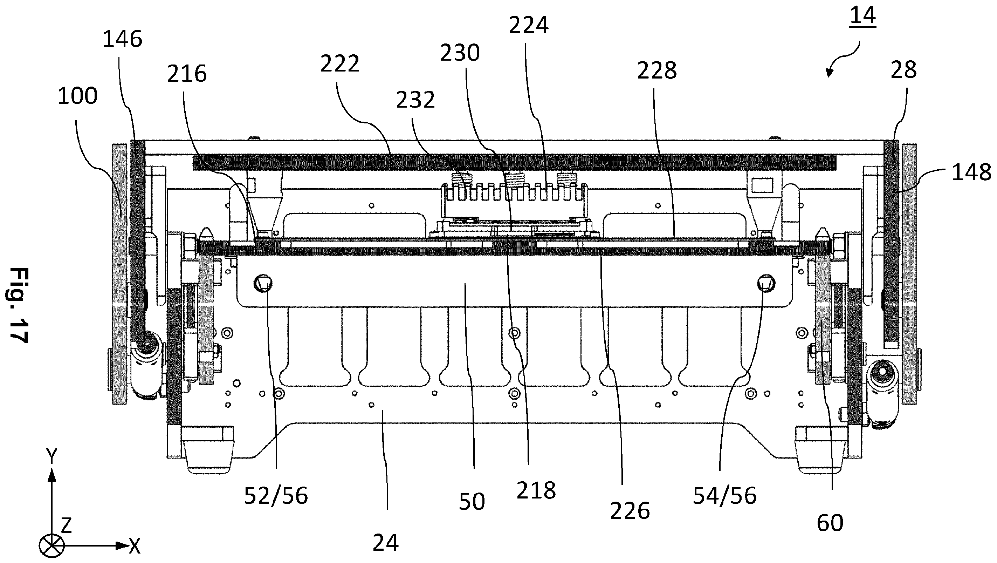

Figuren 16 und 17 zeigen eine weitere Ausführungsform des modularen Testsystems 10. Im Unterschied zu der zuvor beschriebenen Ausführungsform des modularen Testsystems 10, weist das Testmodul 16 einen Sockel 218 auf, an dem die zu testende elektrische Baugruppe angeordnet werden kann. Ferner weist das Fixierungsmodul 222 eine Sockelabdeckung 224 auf, die im geschlossenen Zustand des Grundmoduls 14 die zu testende elektrische Baugruppe an dem Sockel 218 fixiert.

Insbesondere ist der Sockel 218 an einer Seite des Testmoduls 216 angeordnet, welche im geschlossenen Zustand des Grundmoduls 14 dem Fixierungsmodul 222 zugewandt ist. Ebenso ist die Sockelabdeckung 224 an einer Seite des Fixierungsmoduls 222 angeordnet, welche im geschlossenen Zustand des Grundmoduls 14 dem Testmodul 216 zugewandt ist.

Im geöffneten Zustand des Grundmoduls 14, d. h., wenn das zweite Unterstützungsglied 28 gegenüber dem ersten Unterstützungsglied 24 nach oben verschwenkt ist bzw. das zweite Unterstützungsglied 28 sich am Anfang der ersten Bewegungsphase befindet, ist die zu testende elektrische Baugruppe durch die Sockelabdeckung 224 freigegeben, um die zu testende elektrische Baugruppe auszutauschen.

Wie in Figur 17 gezeigt, wird das Testmodul 216 auf das Aufnahmeglied 60 aufgesetzt, sodass, wie oben für das Testmodul 16, beschrieben das Testmodul 216 durch Verschwenken der ersten Bedieneinheit 72 bewegbar ist und mit dem ersten Unterstützungsglied 24 verriegelt und entriegelt werden kann. Des Weiteren besteht das Testmodul 216 aus einer stabilen Tragschicht 226, welche auf das Aufnahmeglied 60 aufgesetzt wird. Auf einer dem Fixierungsmodul 222 zugewandten Seite der Tragschicht 226 ist eine Substratschicht 228, beispielsweise eine Leiterplatte, angeordnet mit der der Sockel 218 verbunden ist.

Ferner weist der Sockel 218 und/oder die Sockelabdeckung 224 elektrische Kontaktierungsmittel auf, welche dazu ausgebildet sind, die zu testende elektrische Baugruppe elektrisch zu kontaktieren. Ferner können die elektrischen Kontaktierungsmittel mit der Testvorrichtung 12 verbunden werden, sodass die zu testende elektrische Baugruppe einem Testverfahren bzw. Prüfverfahren unterzogen werden kann. Bevorzugt können die elektrischen Kontaktierungsmittel Fine-Pitch Felder zum elektrischen Kontaktieren der zu testenden elektrischen Baugruppe aufweisen.

Ferner umschließen der Sockel 218 und die Sockelabdeckung 224 im geschlossenen Zustand des Grundmoduls 14 einen Testraum 230, in dem die zu testende elektrische Baugruppe angeordnet werden kann. Ferner kann das Testsystem 10 dazu ausgebildet sein, einen Umweltparameter in dem Testraum 230 zu regeln bzw. zu steuern. Der Umweltparameter kann beispielsweise die Temperatur, die Luftfeuchte und/oder den Luftdruck innerhalb des Testraums 30 betreffen. Vorzugsweise ist der Sockel 218 und die Sockelabdeckung 224 massiv ausgebildet, beispielsweise aus Aluminium. Des Weiteren kann der Sockel 218 und/oder die Sockelabdeckung 224 Kühlrippen 232 aufweisen, um den Wärmeabtransport zu verbessern.

Ferner können die Sockelabdeckung 224 und/oder der Sockel 218 schwimmend an dem Fixierungsmodul 222 bzw. an dem Testmodul 216 angeordnet sein. Ebenso wie das Testmodul 16, kann das Testmodul 216 an der Rückseite 50 zwei Öffnungen zweiundfünfzig und vierundfünfzig aufweisen, welche beim Verriegeln des Testmoduls 216 auf die Bolzen 56 der Rückwand 36 aufschiebbar sind.

### Bezugszeichenliste

- 10: modulares Testsystem
- 12: Testvorrichtung
- 14: Grundmodul
- 16: Testmodul
- 18: Schnittstellenmodul
- 20: erster Kontaktierungsabschnitt Testmodul
- 22: Fixierungsmodul
- 24: erstes Unterstützungsglied
- 26: Aufnahmeraum
- 28: zweites Unterstützungsglied
- 30, 32: Seitenwände des ersten Unterstützungsglieds
- 34: Vorderwand des ersten Unterstützungsglieds
- 36: Rückwand des ersten Unterstützungsglieds
- 38: Aussparungen
- 40: zweiter Kontaktierungsabschnitt Testmodul
- 42: Gehäuse des Testmoduls
- 44: Oberseite des Testmodul
- 46, 48: Griffe
- 50: Rückseite des Testmoduls
- 52, 54: Öffnungen an Rückseite
- 56: Bolzen an Rückwand
- 60: Aufnahmeglied
- 61: Vorsprung Aufnahmeglied
- 62: erstes Aufnahmeelement
- 63: Ausbuchtung Testmodul
- 64: zweites Aufnahmeelement
- 66: horizontal liegende Enden
- 68: Aussparrungen
- 70: Lagerelemente
- 71: erstes Nockenelement
- 72: erste Bedieneinheit
- 73: Griff
- 74: erste Kulissenführung
- 75: Schenkel erste Bedieneinheit
- 76: grundmodulseitigen Kontaktierungsabschnitt
- 78: Aufnahmepunkte
- 80: Aufnahmeöffnung
- 82: Verriegelung
- 84, 86: Verriegelungselemente
- 100: zweite Bedieneinheit
- 102: zweite Kulissenführung
- 104: zweites Nockenelement
- 106: geschwungener Abschnitt
- 108: erster linearer Abschnitt
- 110: zweiter linearer Abschnitt
- 112: Aufnahmepunkt
- 114: erstes Langloch
- 116: Federelement
- 118: erstes Ende des Langlochs
- 120: zweites Ende des Langlochs
- 122: federgelagerter Anschlag
- 124: Auflagerpunkt
- 126: zweites Langloch federgelagerter Anschlag
- 128: Anschlagelement
- 130: Federelement
- 132: dritte Kulissenführung
- 134: drittes Nockenelement
- 136: erster Abschnitt dritte Kulissenführung
- 138: zweiter Abschnitt dritte Kulissenführung
- 140: Seitenabschnitt zweite Bedieneinheit
- 142: Seitenabschnitt zweite Bedieneinheit
- 144: Griff zweite Bedieneinheit
- 146: Seitenelement zweites Unterstützungsglied
- 148: Seitenelement zweites Unterstützungsglied
- 150: Federunterstützungselement
- 216: Testmodul
- 218: Sockel
- 222: Fixierungsmodul
- 224: Sockelabdeckung
- 226: Tragschicht
- 228: Substratschicht
- 230: Testraum
- 232: Kühlrippen
- P1: erste Anschlagposition
- P2: zweite Anschlagposition

## Patentansprüche

1. Verschließbares Grundmodul (14) für ein modulares Testsystem (10), aufweisend:
ein erstes Unterstützungsglied (24) und ein zweites Unterstützungsglied (28), wobei das zweite Unterstützungsglied (28) an dem ersten Unterstützungsglied verschwenkbar in Bezug auf das erste Unterstützungsglied angeordnet ist und wobei das erste Unterstützungsglied (24) einen Aufnahmeraum (26) zum Anordnen eines Testmoduls (16) bereitstellt, wobei in einem geöffneten Zustand des Grundmoduls (14) das Testmodul (16) austauschbar ist,
wobei das erste Unterstützungsglied (24) zwei gegenüberliegend angeordnete Seitenwände (30) und (32) aufweist, welche an einem Ende mit einer Vorderwand (34) des ersten Unterstützungsglieds (24) und an dem anderen Ende mit einer Rückwand (36) des ersten Unterstützungsglieds (24) verbunden sind, so dass das erste Unterstützungsglied (24) einen rechteckig geformten Rahmen bildet, welcher den Aufnahmeraum (26) bereitstellt,
wobei das Testmodul (16) einen ersten Kontaktierungsabschnitt (20) zum Aufnehmen und elektrischen Kontaktieren einer zu testenden elektrischen Baugruppe und einen mit dem ersten Kontaktierungsabschnitt (20) elektrisch verbundenen zweiten Kontaktierungsabschnitt (40) aufweist, und
ein mit dem Testmodul (16) elektrisch verbindbares Schnittstellenmodul (18),
wobei das Schnittstellenmodul (18) einen grundmodulseitigen Kontaktierungsabschnitt (76) aufweist,
wobei der grundmodulseitige Kontaktierungsabschnitt (76) des Schnittstellenmoduls mittels Kontaktverbindern elektrisch mit dem zweiten Kontaktierungsabschnitt (40) verbindbar ist, um das Testmodul (16) mit einer Testvorrichtung (12) zum Testen der elektrischen Baugruppe zu verbinden, **dadurch gekennzeichnet, dass**
das Schnittstellenmodul (18) lösbar an einer Außenseite der Rückwand (36) des ersten Unterstützungsglieds (24) angeordnet ist, indem das Schnittstellenmodul (18) an dem Grundmodul (14) verschraubbar oder verriegelbar ist oder das Schnittstellenmodul (18) an das Grundmodul (14) klemmbar ist.

2. Grundmodul nach Anspruch 1, wobei das Grundmodul (14) dazu ausgebildet ist, im geöffneten Zustand des Grundmoduls (14), das Testmodul (16) freizugeben, sodass das Testmodul (16) durch ein anderes Testmodul (16) austauschbar ist.

3. Grundmodul nach Anspruch 1 oder 2, weiter aufweisen ein Fixierungsmodul (22), welches dazu ausgebildet ist, im geschlossenen Zustand des Grundmoduls (14), eine zu testende elektrische Baugruppe an dem ersten Kontaktierungsabschnitt (20) zu fixieren und wobei das Fixierungsmodul (22) mittels einer Verriegelung (82) mit dem Grundmodul (14) kuppelbar ist.

4. Grundmodul nach Anspruch 3, wobei das Fixierungsmodul (22) und das Testmodul (16) aufeinander abgestimmt sind.

5. Grundmodul nach einem der vorangegangenen Ansprüche, wobei das Schnittstellenmodul (18) dazu ausgebildet ist, das Testmodul (16) unmittelbar mit der Testvorrichtung (12) zu verbinden.

6. Grundmodul nach einem der vorangegangenen Ansprüche, wobei das Schnittstellenmodul (18) einen testvorrichtungsseitigen Kontaktierungsabschnitt aufweist, der dazu ausgebildet, das Schnittstellenmodul (18) mit der Testvorrichtung (12) zu verbinden.

7. Grundmodul nach einem der Ansprüche 1 bis 6, wobei die Kontaktverbinder als Pylonstecker ausgebildet sind.

8. Grundmodul nach einem der vorangegangenen Ansprüche, ferner aufweisend eine Bedieneinheit (72), wobei durch Betätigen der Bedieneinheit (72) der zweite Kontaktierungsabschnitt (40) von dem Schnittstellenmodul (18) elektrisch und/oder physisch trennbar und/oder mit diesem verbindbar ist.

9. Grundmodul einem der vorangegangenen Ansprüche, ferner aufweisend eine Bedieneinheit (72), wobei durch Betätigen der Bedieneinheit (72) das Testmodul (16) eine Relativbewegung in Bezug auf das Schnittstellenmodul (18) erfährt, um das Testmodul (16) elektrisch und/oder physisch von dem Schnittstellenmodul (18) zu trennen und/oder mit diesem zu verbinden.

10. Grundmodul nach einem der vorangegangenen Ansprüche, wobei der erste Kontaktierungsabschnitt (20) und der zweite Kontaktierungsabschnitt (40) zumindest teilweise mittels Wire-Wrapping elektrische verbunden sind; und/oder
wobei der grundmodulseitige Kontaktierungsabschnitt (76) des Schnittstellenmoduls (18) zumindest teilweise mittels Wire-Wrapping mit einem testvorrichtungsseitigen Kontaktierungsabschnitt des Schnittstellenmoduls (18) verbunden ist.

11. Modulares Testsystem (10) zum Testen einer elektrischen Baugruppe, aufweisend:
- ein verschließbares Grundmodul (14) nach einem der Ansprüche 1 bis 10; und
- ein Testmodul (16), wobei das Testmodul (16) aufweist:
- einen ersten Kontaktierungsabschnitt (20) zum Aufnehmen und elektrischen Kontaktieren einer zu testenden elektrischen Baugruppe, und
- einen mit dem ersten Kontaktierungsabschnitt (20) elektrisch verbundenen zweiten Kontaktierungsabschnitt (40) zum elektrischen Verbinden der zu testenden elektrischen Baugruppe mit dem Schnittstellenmodul (18).

12. Verfahren zum Testen elektrischer Baugruppen, aufweisend:
Bereitstellen eines modularen Testsystems (10) nach Anspruch 11;
Verbinden des Schnittstellenmoduls (18) mit einer Testvorrichtung (12);
Anordnen des Testmoduls (16) in dem Aufnahmeraum (26) des Grundmoduls (14);
Aufnehmen einer zu testenden elektrischen Baugruppe durch den ersten Kontaktierungsabschnitt (20) des Testmoduls (16);
Verschließen des Grundmoduls (14); und
Testen der elektrischen Baugruppe mittels der Testvorrichtung (12).

13. Verfahren nach Anspruch 12, weiter aufweisend:
Öffnen des Grundmoduls (14);
Austauschen des Testmoduls (16) durch ein anderes Testmodul (16);
Aufnehmen einer zu testenden elektrischen Baugruppe durch den ersten Kontaktierungsabschnitt (20) des anderen Testmoduls (16);
Verschließen des Grundmoduls (14); und
Testen der elektrischen Baugruppe mittels der Testvorrichtung (12).

## Claims

1. A closable base module (14) for a modular test system (10), comprising:
a first support member (24) and a second support member (28), wherein the second support member (28) is arranged on the first support member so as to be pivotable in relation to the first support member and wherein the first support member (24) provides a receiving space (26) for arranging a test module (16), wherein the test module (16) is replaceable in an opened state of the base module (14),
wherein the first support member (24) comprises two oppositely arranged side walls (30) and (32) which are connected at one end to a front wall (34) of the first support member (24) and at the other end to a rear wall (36) of the first support member (24), such that the first support member (24) forms a rectangular frame that provides the receiving space (26),
wherein the test module (16) comprises a first contacting portion (20) for receiving and electrically contacting an electrical assembly to be tested and a second contacting portion (40) that is electrically connected to the first contacting portion (20); and
an interface module (18) that can be electrically connected to the test module (16),
wherein the interface module (18) comprises a base module-side contacting portion (76),
wherein the base module-side contacting portion (76) of the interface module can be electrically connected to the second contacting portion (40) via contact connectors in order to connect the test module (16) to a test device (12) for testing the electrical assembly, **characterized in that** the interface module (18) is detachably arranged on an outer face of the rear wall (36) of the first support member (24) by the interface module (18) being screwable or lockable to the base module (14) or by the interface module (18) being clampable to the base module (14).

2. The base module according to claim 1, wherein the base module (14) is designed to release the test module (16) in the opened state of the base module (14), such that the test module (16) can be replaced with another test module (16).

3. The base module according to claim 1 or 2, further comprising a securing module (22) which is designed to secure an electrical assembly to be tested to the first contacting portion (20) in the closed state of the base module (14) and wherein the securing module (22) can be coupled to the base module (14) via a locking mechanism (82).

4. The base module according to claim 3, wherein the securing module (22) and the test module (16) are coordinated with one another.

5. The base module according to any one of the preceding claims, wherein the interface module (18) is designed to connect the test module (16) directly to the test device (12).

6. The base module according to any one of the preceding claims, wherein the interface module (18) comprises a test device-side contacting portion that is designed to connect the interface module (18) to the test device (12).

7. The base module according to any one of claims 1 to 6, wherein the contact connectors are designed as pylon plugs.

8. The base module according to any one of the preceding claims, further comprising an operating unit (72), wherein the second contacting portion (40) can be electrically and/or physically disconnected from and/or connected to the interface module (18) by means of actuation of the operating unit (72).

9. The base module according to any one of the preceding claims, further comprising an operating unit (72), wherein the test module (16) undergoes a relative movement in relation to the interface module (18) by means of actuation of the operating unit (72) in order to electrically and/or physically disconnect the test module (16) from and/or connect same to the interface module (18).

10. The base module according to any one of the preceding claims, wherein the first contacting portion (20) and the second contacting portion (40) are electrically connected at least partially via wire wrapping; and/or
wherein the base module-side contacting portion (76) of the interface module (18) is connected to a test device-side contacting portion of the interface module (18) at least partially via wire wrapping.

11. A modular test system (10) for testing an electrical assembly, comprising:
- a closable base module (14) according to any one of claims 1 to 10; and
- a test module (16), wherein the test module (16) comprises:
- a first contacting portion (20) for receiving and electrically contacting an electrical assembly to be tested, and
- a second contacting portion (40) that is electrically connected to the first contacting portion (20) for electrically connecting the electrical assembly to be tested to the interface module (18).

12. A method for testing electrical assemblies, comprising:
providing a modular test system (10) according to claim 11;
connecting the interface module (18) to a test device (12);
arranging the test module (16) in the receiving space (26) of the base module (14);
receiving an electrical assembly to be tested by means of the first contacting portion (20) of the test module (16);
closing the base module (14); and
testing the electrical assembly using the test device (12).

13. The method according to claim 12, further comprising:
opening the base module (14);
replacing the test module (16) with another test module (16);
receiving an electrical assembly to be tested by means of the first contacting portion (20) of the other test module (16);
closing the base module (14); and
testing the electrical assembly using the test device (12).

## Revendications

1. Module de base refermable (14) pour un système d'essai modulaire (10), présentant :
un premier organe de support (24) et un deuxième organe de support (28), dans lequel le deuxième organe de support (28) est disposé sur le premier organe de support de manière à pouvoir pivoter par rapport au premier organe de support et dans lequel le premier organe de support (24) fournit un espace de réception (26) pour l'agencement d'un module d'essai (16), dans lequel, dans un état ouvert du module de base (14), le module d'essai (16) est remplaçable,
dans lequel le premier organe de support (24) présente deux parois latérales (30) et (32) disposées l'une en face de l'autre, lesquelles sont reliées à une paroi avant (34) du premier organe de support (24) à une extrémité et à une paroi arrière (36) du premier organe de support (24) à l'autre extrémité, de telle façon que le premier organe de support (24) constitue un cadre de forme rectangulaire, lequel fournit l'espace de réception (26),
dans lequel le module d'essai (16) présente une première section de mise en contact (20) pour la réception et la mise en contact électrique d'un premier composant électrique à tester et une deuxième section de mise en contact (40) reliée électriquement à la première section de mise en contact (20) ; et
un module d'interface (18) apte à être relié électriquement au module d'essai (16),
dans lequel le module d'interface (18) présente une section de mise en contact côté module de base (76),
dans lequel la section de mise en contact côté module de base (76) du module d'interface peut être reliée électriquement à la deuxième section de mise en contact (40) au moyen de connecteurs de contact, afin de relier le module d'essai (16) à un dispositif d'essai (12) pour tester le composant électrique, **caractérisé en ce que**
le module d'interface (18) est disposé de façon amovible sur un côté extérieur de la paroi arrière (36) du premier organe de support (24), du fait que le module d'interface (18) peut être vissé ou verrouillé sur le module de base (14) ou que le module d'interface (18) peut être serré sur le module de base (14).

2. Module de base selon la revendication 1, dans lequel le module de base (14) est conçu pour libérer le module d'essai (16) dans l'état ouvert du module de base (14), de manière à ce que le module d'essai (16) puisse être remplacé par un autre module d'essai (16).

3. Module de base selon la revendication 1 ou 2, présentant en outre un module de fixation (22), lequel est conçu pour fixer un composant électrique à tester à la première section de mise en contact (20) dans l'état fermé du module de base (14), et dans lequel le module de fixation (22) peut être accouplé au module de base (14) au moyen d'un élément de verrouillage (82).

4. Module de base selon la revendication 3, dans lequel le module de fixation (22) et le module d'essai (16) sont adaptés l'un à l'autre.

5. Module de base selon l'une des revendications précédentes, dans lequel le module d'interface (18) est conçu pour relier le module d'essai (16) directement au dispositif d'essai (12).

6. Module de base selon l'une des revendications précédentes, dans lequel le module d'interface (18) présente une section de mise en contact côté dispositif d'essai, laquelle est conçue pour relier le module d'interface (18) au dispositif d'essai (12).

7. Module de base selon l'une des revendications 1 à 6, dans lequel le connecteur de contact est conçu comme une prise Pylon.

8. Module de base selon l'une des revendications précédentes, présentant en outre une unité de commande (72), moyennant quoi, par actionnement de l'unité de commande (72), la deuxième section de mise en contact (40) peut être séparée électriquement et/ou physiquement du module d'interface (18) et/ou reliée à celui-ci.

9. Module de base selon l'une des revendications précédentes, présentant en outre une unité de commande (72), dans lequel, par actionnement de l'unité de commande (72), le module d'essai (16) subit un mouvement relatif par rapport au module d'interface (18), afin de séparer le module d'essai (16) électriquement et/ou physiquement du module d'interface (18) et/ou de le relier à celui-ci.

10. Module de base selon l'une des revendications précédentes, dans lequel la première section de mise en contact (20) et la deuxième section de mise en contact (40) sont au moins partiellement reliés électriquement au moyen d'un enroulement de fil ; et/ou
dans lequel la section de mise en contact côté module de base (76) du module d'interface (18) est reliée au moins partiellement à une section de mise en contact côté dispositif d'essai du module d'interface (18) au moyen d'un enroulement de fil.

11. Système d'essai modulaire (10) destiné à tester un composant électrique, présentant :
- un module de base refermable (14) selon l'une des revendications 1 à 10 ; et
- un module d'essai (16), dans lequel le module d'essai (16) présente :
- une première section de mise en contact (20) pour la réception et la mise en contact électrique d'un composant électrique à tester, et
- une deuxième section de mise en contact (40) reliée électriquement à la première section de mise en contact (20), pour la connexion électrique du composant électrique à tester au module d'interface (18).

12. Procédé d'essai de composants électriques, présentant :
la mise à disposition d'un système d'essai modulaire (10) selon la revendication 11;
la liaison du module d'interface (18) à un dispositif d'essai (12) ;
l'agencement du module d'essai (16) dans l'espace de réception (26) du module de base (14) ;
la réception d'un composant électrique à tester par la première section de mise en contact (20) du module d'essai (16) ;
la fermeture du module de base (14) ; et
le test du composant électrique au moyen du dispositif d'essai (12).

13. Procédé selon la revendication 12, présentant en outre :
l'ouverture du module de base (14) ;
le remplacement du module d'essai (16) par un autre module d'essai (16) ;
la réception d'un composant électrique à tester par la première section de mise en contact (20) de l'autre module d'essai (16) ;
la fermeture du module de base (14) ; et
le test du composant électrique au moyen du dispositif d'essai (12).
